# EUROPEAN PATENT SPECIFICATION

(11) **EP 4 550 081 B1**
(45) Date of publication and mention of the grant of the patent: **02.09.2026**
(21) Application number: 23831966.9
(22) Date of filing: 30.06.2023
(51) Int. Cl.: G06F 1/16, H04M 1/02, F16C 11/04, G06F 1/20

(54) **ELECTRONIC DEVICE COMPRISING HINGE-LINKED FOOT STRUCTURE**
ELEKTRONISCHE VORRICHTUNG MIT GELENKVERBUNDENER FUSSSTRUKTUR
DISPOSITIF ÉLECTRONIQUE COMPRENANT UNE STRUCTURE DE PIED LIÉE À UNE CHARNIÈRE

(30) Priority: 30.06.2022 KR 20220080797; 07.09.2022 KR 20220113763
(43) Date of publication of application: 07.05.2025
(73) Proprietor: Samsung Electronics Co., Ltd., Suwon-si, Gyeonggi-do 16677 (KR)
(72) Inventor: NOH, Hwanmyung, Suwon-si Gyeonggi-do 16677 (KR); LEE, Seungwoon, Suwon-si Gyeonggi-do 16677 (KR)
(74) Representative: Gulde & Partner
(86) International application number: PCT/KR2023/009272
(87) International publication number: WO 2024/005608

(56) References cited:
- CN-A- 110 442 188
- CN-U- 210 639 543
- KR-A- 20220 028 364
- US-A1- 2013 229 753
- US-A1- 2018 267 570

## Description

### [Technical Field]

An embodiment disclosed herein relates to an electronic device that includes a hinge module and a foot structure that operates in conjunction with the rotation of the hinge module.

### [Background Art]

The term "electronic device" may refer to a device, such as a home appliance, an electronic scheduler, a portable multimedia player, a mobile communication terminal, a tablet personal computer (PC), a video/audio device, a desktop/laptop PC, or a vehicle navigation system, that performs a specific function based on an installed program. For example, these electronic devices may output stored information as sound or images. As the integration degree of electronic devices increases and ultra-highspeed and high-capacity wireless communication become more widespread, a single electronic device such as a mobile communication terminal may now be equipped with various functions. For example, not only communication functions but also entertainment functions such as gaming, multimedia functions such as music and video playback, communication and security functions for mobile banking, or various function such as schedule management or electronic wallet are being integrated into a single electronic device. These electronic devices are being miniaturized to be conveniently carried by users.

As mobile communication service extends into the multimedia service domain, it is necessary to increase the display sizes of electronic devices in order to allow users to fully utilize multimedia services, as well as voice call and short message services. However, the display sizes of electronic devices are in a trade-off relationship with the miniaturization thereof.

An example of a prior art document is KR 2022 0028364 A, that discloses a portable electronic device having a foldable flexible display. The electronic device can rotate a first housing and a second housing connected to a hinge between a folded state, in which both housings are located one above the other, and an unfolded state, in which both housings are located side by side in a flat configuration, in order to increase the display size when the electronic device is used.

### [DETAILED DESCRIPTION OF THE INVENTION]

### [Technical Solution]

According to an embodiment disclosed herein, an electronic device may include a first housing, a second housing, a hinge module disposed between the first housing and the second housing and rotatably connecting the second housing to the first housing, and a flexible display disposed across one surface of the first housing, the hinge module, and one surface of the second housing. The electronic device may include a foot structure disposed adjacent to an outer surface of the first housing, and the foot structure may include a first member on which a guide slot is formed. The electronic device may include a link structure including a first link member connected to the hinge module and a second link member connecting the first link member and the guide slot. The second link member may be movable along the guide slot in conjunction with rotation of at least one of the first housing or the second housing by the hinge module. The foot structure may be movable in a first direction toward an exterior of the first housing or in a second direction opposite to the first direction in conjunction with movement of the second link member.

### [BRIEF DESCRIPTION OF DRAWINGS]

FIG. 1 is a block diagram of an electronic device in a network environment according to an embodiment of the disclosure;
FIG. 2 is a view illustrating an electronic device in an unfolded state according to an embodiment of the disclosure;
FIG. 3 is a view illustrating an electronic device in a folded state according to an embodiment of the disclosure;
FIG. 4 is an exploded perspective view illustrating the electronic device according to an embodiment of the disclosure;
FIG. 5 is a view illustrating an internal structure and a foot assembly of the electronic device according to an embodiment of the disclosure;
FIG. 6 is a view illustrating a part of the hinge module and the foot structure according to an embodiment of the disclosure;
FIG. 7 is an exploded perspective view of a part of the hinge module, the link structure, and the foot structure according to an embodiment of the disclosure;
FIG. 8A is a view illustrating the operation of the foot structure according to an embodiment of the disclosure;
FIG. 8B is a view illustrating the operation of the foot structure according to an embodiment of the disclosure;
FIG. 9 is an exploded perspective view illustrating the electronic device according to an embodiment of the disclosure;
FIG. 10 is a view illustrating a structure in which a foot structure is mounted on an electronic device according to an embodiment of the disclosure;
FIG. 11 is a plan view of a hinge module and a foot assembly according to an embodiment of the disclosure;
FIG. 12 is an exploded perspective view of a hinge module, a link structure, and a foot structure according to an embodiment of the disclosure;
FIG. 13 is a view illustrating a guide slot of a foot structure according to an embodiment of the disclosure;
FIG. 14A is a view illustrating a link structure and a foot structure that move based on an angle between a first housing and a second housing according to an embodiment of the disclosure;
FIG. 14B is a view illustrating the link structure and the foot structure that move based on an angle between the first housing and the second housing according to an embodiment of the disclosure;
FIG. 14C is a view illustrating the link structure and the foot structure that move based on an angle between the first housing and the second housing according to an embodiment of the disclosure;
FIG. 14D is a view illustrating the link structure and the foot structure that move based on an angle between the first housing and the second housing according to an embodiment of the disclosure;
FIG. 14E is a view illustrating the link structure and the foot structure that move based on an angle between the first housing and the second housing according to an embodiment of the disclosure;
FIG. 14F is a view illustrating the link structure and the foot structure that move based on an angle between the first housing and the second housing according to an embodiment of the disclosure;
FIG. 15A is a view illustrating a foot structure and a plate member according to an embodiment of the disclosure; and
FIG. 15B is a view illustrating the foot structure and the plate member according to an embodiment of the disclosure.

### [MODE FOR CARRYING OUT THE INVENTION]

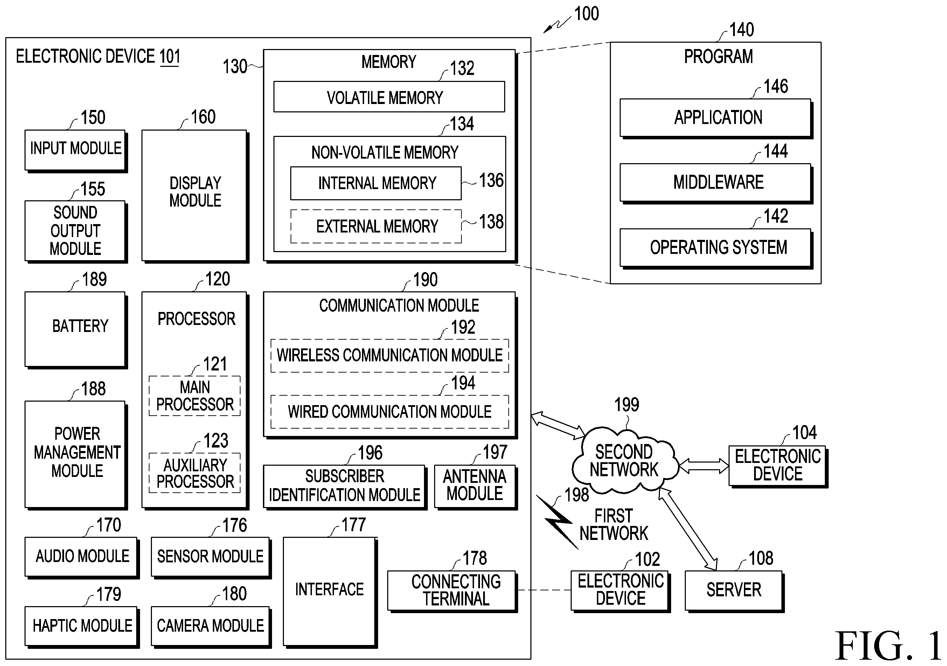

FIG. 1 is a block diagram illustrating an electronic device 101 in a network environment 100 according to an embodiment of the disclosure.

Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a fifth generation (5G) network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a fourth generation (4G) network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the millimeter wave (mmWave) band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

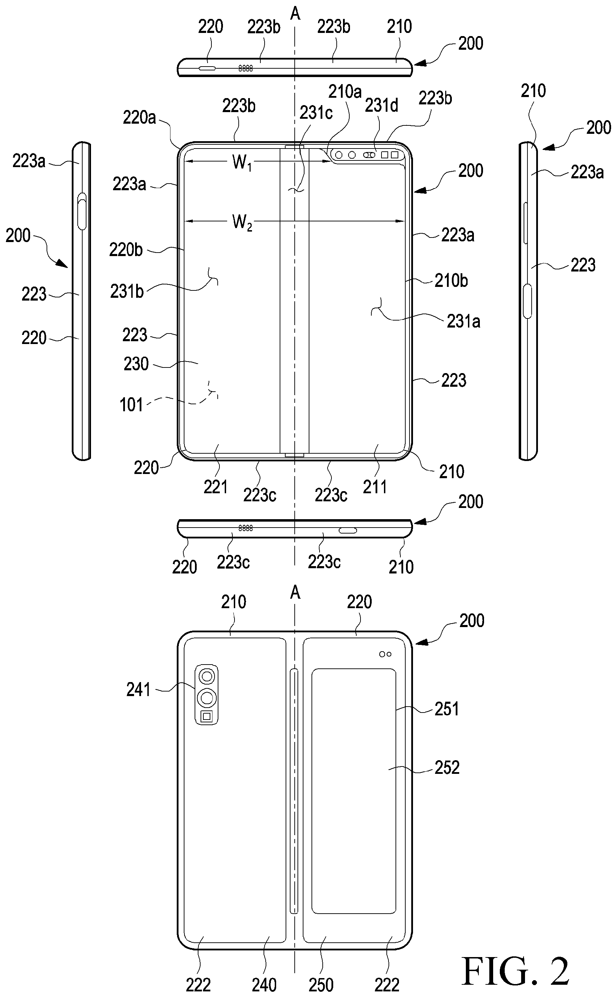

FIG. 2 is a view illustrating an electronic device in an unfolded state according to an embodiment of the disclosure.

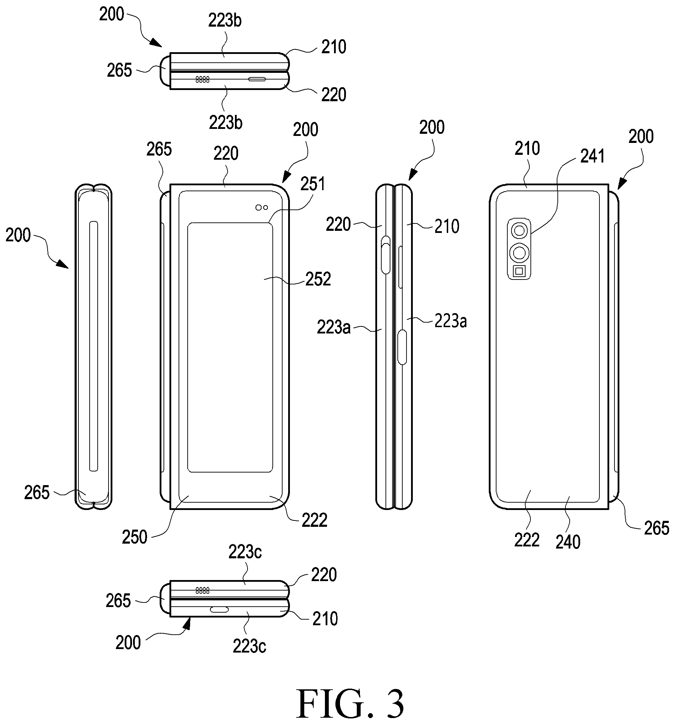

FIG. 3 is a view illustrating an electronic device in a folded state according to an embodiment of the disclosure.

The configuration of the electronic device 200 of FIGS. 2 and 3 may be entirely or partially identical to that of the electronic device 101 of FIG. 1.

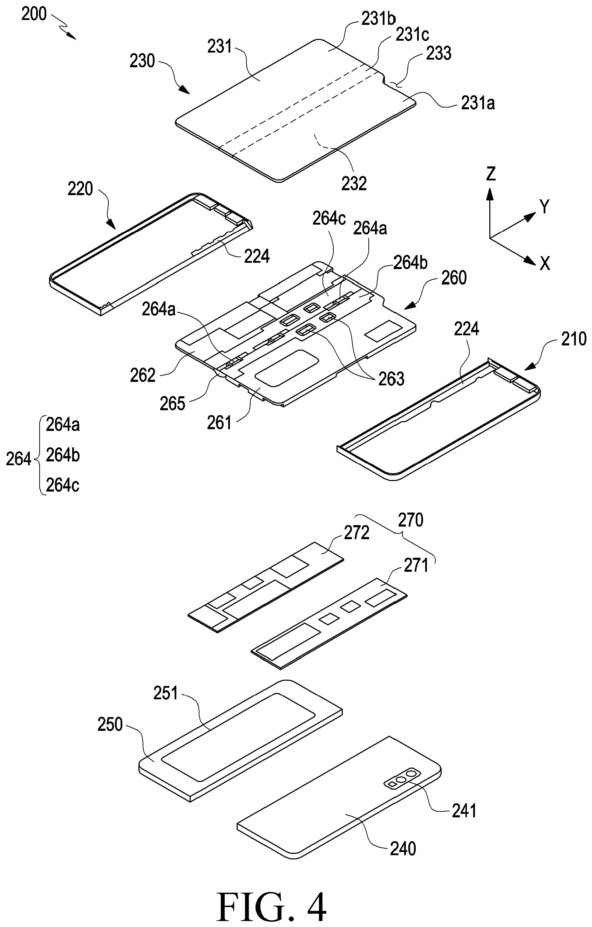

Referring to FIGS. 2 and 3, the electronic device 200 may include a pair of housings 210 and 220 that are rotatably coupled to each other via a hinge module (e.g., the hinge module 264 in FIG. 4) to be foldable relative to each other, a hinge cover 265 that covers the foldable portion of the pair of housings 210 and 220, and a display 230 (e.g., the flexible or foldable display) disposed in a space defined by the pair of housings 210 and 220. The configuration of the display 230 in FIGS. 2 and/or 3 may be entirely or partially identical to that of the display module 160 in FIG. 1. In an embodiment, the electronic device 200 may include a foldable housing in which the pair of housings 210 and 220 are coupled to be rotatable from a position at which the pair of housings 210 and 220 are folded to face each other to a position at which the pair of housings 210 and 220 are unfolded to be parallel to each other. Herein, the surface on which the display 230 is disposed may be defined as the front surface of the electronic device 200, and the surface opposite the front surface may be defined as the rear surface of the electronic device 200. In addition, the surface surrounding the space between the front surface and the rear surface may be defined as the side surface of the electronic device 200.

In an embodiment, the pair of housings 210 and 220 may include a first housing 210 including a sensor area 231d, a second housing 220, a first rear surface cover 240, and a second rear surface cover 250. The pair of housings 210 and 220 of the electronic device 200 are not limited to the shape and assembly illustrated in FIGS. 2 and 3, but may be implemented by other shapes or other combinations and/or assemblies of components. For example, in an embodiment, the first housing 210 and the first rear surface cover 240 may be integrally configured, and the second housing 220 and the second rear surface cover 250 may be integrally configured. In an embodiment, the first housing 210 may include the first rear surface cover 240, and the second housing 220 may include the second rear surface cover 250.

In an embodiment, the first housing 210 and the second housing 220 may be disposed, for example, on opposite sides about the folding axis A and may have generally symmetrical shapes with respect to the folding axis A. In some embodiments, the first housing 210 and the second housing 220 are rotatable about different folding axes, respectively, with respect to the hinge module 264 or the hinge cover 265. For example, the first housing 210 and the second housing 220 may be individually coupled to the hinge module 264 or the hinge cover 265 to be rotatable, and the first and second housings may be rotated about the folding axis A or about different folding axes, respectively, between a folded position, an inclined position, and a parallel unfolded position relative to each other.

Herein, the description "positioned side by side" or "extending side by side" may refer to the state in which two structures (e.g., the housings 210 and 220) are at least partially positioned side by side or in which at least portions that are positioned next to each other are arranged parallel. According to some embodiments, the description "arranged side by side" may refer to two structures being positioned next to each other and oriented in parallel directions or in the same direction. Expressions such as "side by side" and "parallel" may be used in the following detailed description, which will be readily understood according to the shapes or arrangements of the structures with reference to the accompanying drawings or the like.

In an embodiment, the angle or distance between the first housing 210 and the second housing 220 may vary depending on whether the electronic device 200 is in the unfolded state (an extended state, a flat state, or an open state), in the folded state (or a closed), or in the intermediate state. In describing an embodiment disclosed herein, the electronic device 200 being in the "unfolded state" may referred to the "fully unfolded state" in which the first housing 210 and the second housing 220 of the electronic device form 180 degrees. The electronic device 200 being in the "closed state" may refer to the state in which the first housing 210 and the second housing 220 of the electronic device form an angle of 0 degrees or up to 10 degrees. The electronic device 200 being in the "intermediate state" may refer to the state in which the first housing 210 and the second housing 220 form an angle between the angle formed in the "unfolded state" and the angle formed in the "closed state".

In an embodiment, the first housing 210 additionally includes a sensor area 231d in which various sensors are disposed, unlike the second housing 220, but the first housing 210 and the second housing 220 may have mutually symmetrical shapes in other areas. In an embodiment, the sensor area 231d may be additionally disposed or replaced in at least a portion of the second housing 220. In an embodiment, the sensor area 231d may be omitted from the first housing 210. The configuration of the sensor area 231d in FIG. 2 and/or FIG. 3 may be entirely or partially identical to that of the sensor module 176 in FIG. 1.

In an embodiment, in the unfolded state of the electronic device 200, the first housing 210 may include a first surface 211 connected to a hinge module (e.g., the hinge module 264 in FIG. 4) and disposed to face the front surface of the electronic device 200, a second surface 212 facing away from the first surface 211, and a first side member 213 surrounding at least a portion of the space between the first surface 211 and the second surface 212. In an embodiment, the first side member 213 may include a first side surface 28a arranged parallel to the folding axis A, a second side surface 28b extending from one end of the first side surface 28a in a direction perpendicular to the folding axis A, and a third side surface 213c extending from the other end of the first side surface 28a in a direction perpendicular to the folding axis A. In describing various embodiments of the disclosure, terms such as "parallel" or "perpendicular" are used in connection with the arrangements of the above-described side faces, but in some embodiments, the terms may include the meaning of "partially parallel" or "partially perpendicular". In some embodiments, terms such as "parallel" or "perpendicular" may include an inclined arrangement within an angle of 10 degrees.

In an embodiment, when the electronic device 200 is in the unfolded state, the second housing 220, which is connected to the hinge module (e.g., the hinge module 264 in FIG. 4), may include a third surface 221 and arranged to face the front of the electronic device 200, a fourth surface 222 facing away from the third surface 221, and a second side member 223 surrounding at least part of the space between the third surface 221 and the fourth surface 222. In an embodiment, the second side member 223 may include a fourth side surface 223a arranged parallel to the folding axis A, a fifth side surface 223b extending from one end of the fourth side surface 223a in a direction perpendicular to the folding axis A, and a sixth side surface 223c extending from the other end of the fourth side surface 223a in a direction perpendicular to the folding axis A. In an embodiment, in the folded state, the third surface 221 may be disposed to face the first surface 211. In some embodiments, although there are some differences in specific shapes, the second side member 223 may be made, in shape or material, to be substantially the same as the first side member 213.

In an embodiment, the electronic device 200 may include a recess provided to accommodate the display 230 through structural shape coupling of the first housing 210 and the second housing 220. The recess may have substantially the same size as the display 230. In an embodiment, due to the sensor area 231d, the recess may have two or more different widths in a direction perpendicular to the folding axis A. For example, the recess may have a first width W₁ between a first portion 220a of the second housing 220, which is parallel to the folding axis A, and a first portion 210a provided at an edge of the sensor area 231d of the first housing 210, and a second width W₂ between a second portion 220b of the second housing 220 and a second portion 210b of the first housing 210, which does not correspond to the sensor area 231d and is parallel to the folding axis A. In this case, the second width W₂ may be greater than the first width W₁. For example, the recess may have the first width W₁ from the first portion 210a of the first housing 210 to the first portion 220a of the second housing 220, which are asymmetric to each other, and the second width W₂ from the second portion 210b of the first housing 210 to the second portion 220b of the second housing 220, which are symmetric to each other. In an embodiment, the first portion 210a and the second portion 210b of the first housing 210 may have different distances from the folding axis A. The widths of the recess are not limited to the illustrated example. In an embodiment, the recess may have two or more different widths due to the shape of the sensor area 231d or the asymmetric portions of the first housing 210 and the second housing 220.

In an embodiment, the first housing 210 and the second housing 220 may be at least partially made of a metal material or a non-metal material having the rigidity of a level selected in order to support the display 230. In an embodiment, the first housing 210 and the second housing 220 may at least partially include a conductive material. When the first housing 210 and the second housing 220 include a conductive material, the electronic device 200 may transmit/receive radio waves by using the portions made of the conductive material in the first housing 210 and the second housing 220. For example, a processor or a communication module of the electronic device 200 may perform wireless communication using a portion of the first housing 210 and the second housing 220.

In an embodiment, the sensor area 231d may be have a predetermined area adjacent to one corner of the first housing 210. However, the arrangement, shape, and size of the sensor area 231d are not limited to the illustrated example. For example, in an embodiment, the sensor area 231d may be provided at another corner of the first housing 210 or at any area between the upper and lower corners. In an embodiment, the sensor area 231d may be disposed in at least a portion of the second housing 220. In an embodiment, the sensor area 231d may be disposed to extend over the first housing 210 and the second housing 220. In an embodiment, the electronic device 200 may include components exposed to the front surface of the electronic device 200 through the sensor area 231d or through one or more openings provided in the sensor area 231d, and may perform various functions using these components. In various embodiments, the components disposed in the sensor area 231d may include, for example, at least one of a front camera device, a proximity sensor, an illuminance sensor, an iris recognition sensor, an ultrasonic sensor, or an indicator. However, the disclosure is necessarily limited to such an embodiment. The sensor area 231d may be omitted depending on an embodiment, and such cases, the components arranged in the sensor area 231d may be distributed and arranged in at least a portion of the first housing 210 and/or the second housing 220.

In an embodiment, the first rear surface cover 240 may be disposed on the second surface 212 of the first housing 210 and may have a substantially rectangular periphery. In an embodiment, the periphery of the first rear surface cover 240 may be at least partially wrapped by the first housing 210. Similarly, the second rear surface cover 250 may be disposed on the fourth surface 222 of the second housing 220, and at least a portion of the periphery of the second rear surface cover 250 may be at least partially enclosed by the second housing 220.

In the illustrated embodiment, the first rear surface cover 240 and the second rear surface cover 250 may have substantially symmetrical shapes about the folding axis A. As an embodiment, the first rear surface cover 240 and the second rear surface cover 250 may include various shapes different from each other. In an embodiment, the first rear surface cover 240 may be configured integrally with the first housing 210, and the second rear surface cover 250 may be configured integrally with the second housing 220.

In an embodiment, the first rear surface cover 240, the second rear surface cover 250, the first housing 210, and the second housing 220 may provide, through a mutually coupled structure, the space in which various components (e.g., a printed circuit board, an antenna module, a sensor module, or a battery) of the electronic device 200 may be arranged. In an embodiment, one or more components may be arranged or visually exposed on the rear surface of the electronic device 200. For example, one or more components or sensors may be visually exposed through a first rear surface area 241 of the first rear surface cover 240. In an embodiment, the sensors may include a proximity sensor, a rear camera device, and/or a flash. In an embodiment, at least a portion of a sub-display 252 may be visually exposed through a second rear surface area 251 of the second rear surface cover 250.

The display 230 may be arranged in a space provided by the pair of housings 210 and 220. For example, the display 230 may be seated in the recess defined by the pair of housings 210 and 220, and may be arranged to occupy substantially the majority of the front surface of the electronic device 200. For example, the front surface of the electronic device 200 may include the display 230, as well as an area (e.g., an edge area) of the first housing 210 and an area (e.g., an edge area) of the second housing 220, which are adjacent to the display 230. In an embodiment, the rear surface of the electronic device 200 may include the first rear surface cover 240, an area (e.g., an edge area) of the first housing 210 adjacent to the first rear surface cover 240, the second rear surface cover 250, and an area (e.g., an edge area) of the second housing 220 adjacent to the second rear surface cover 250.

According to an embodiment, the display 230 may refer to a display in which at least one area is transformable into a flat surface or a curved surface. In an embodiment, the display 230 may include a folding area 231c, a first display area 231a disposed on one side of the folding area 231c (e.g., the right area of the folding area 231c), and a second display area 231b disposed on the other side of the folding area 231c (e.g., the left area of the folding area 231c). For example, the first display area 231a may be disposed on the first surface 211 of the first housing 210, and the second display area 231b may be disposed on the third surface 221 of the second housing 220. For example, the display 230 may extend from the first surface 211 to the third surface 221 across the hinge module 264 in FIG. 4, and at least an area corresponding to the hinge module 264 (e.g., the folding area 231c) may be a flexible area that is transformable from a flat plate shape into a curved shape.

The area division of the display 230 is exemplary, and the display 230 may be divided into multiple areas (e.g., four or more areas or two areas) depending on the structure or functions thereof. For example, in the embodiment illustrated in FIG. 2, the folding area 231c extends in the direction of the vertical axis (e.g., the Y axis in FIG. 4) parallel to the folding axis A, and the area of the display 230 may be divided by the folding area 231c or the folding axis (the axis A). However, according an embodiment, the display 230 may be divided into areas based on another folding area (e.g., a folding area parallel to the horizontal axis (e.g., the X axis in FIG. 4)) or another folding axis (e.g., a folding axis parallel to the X axis in FIG. 4). The aforementioned area division of the display is merely physical division based on the pair of housings 210 and 220 and the hinge module (e.g., the hinge module 264 in FIG. 4), and the display 230 may display one full screen substantially through the pair of housings 210 and 220 and the hinge module (e.g., the hinge module 264 in FIG. 4).

According to an embodiment, the first display area 231a and the second display area 231b may have generally symmetrical shapes about the folding area 231c. However, unlike the second display area 231b, the first display area 231a may include a notch area (e.g., the notch area 233 in FIG. 4) that provides the sensor area 231d, and may have a shape symmetrical to the second display area 231b in areas other than the notch area. For example, the first display area 231a and the second display area 231b may include mutually symmetrical portions and mutually asymmetrical portions.

Further referring to FIG. 4, the hinge cover 265 may be disposed between the first housing 210 and the second housing 220 and may be configured to cover internal components (e.g., the hinge module 264 in FIG. 4). In an embodiment, the hinge cover 265 may be covered by a portion of each of the first housings 210 and the second housing 220 or may be exposed to the outside depending on the operating state of the electronic device 200 (the unfolded state (extended state) or the folded state).

Hereinafter, the operation of the first housing 210 and the second housing 220 depending on the states of the electronic device 200 (e.g., the unfolded state (extended state) and the folded state) and each area of the display 230 will be described.

In an embodiment, when the electronic device 200 is in the unfolded state (extended state) (e.g., the state in FIG. 2), the first housing 210 and the second housing 220 may form an angle of 180 degrees, and the first display area 231a and the second display area 231b of the display may be disposed to be oriented in the same direction, for example, to display screens in directions parallel to each other. In addition, the folding area 231c may form the same plane as the first display area 231a and the second display area 232b.

In an embodiment, when the electronic device 200 is in the folded state (e.g., the state in FIG. 3), the first housing 210 and the second housing 220 may be disposed to face each other. For example, when the electronic device 200 is in the folded state (e.g., the state of FIG. 3), the first display area 231a and the second display area 231b of the display 230 may form a narrow angle (e.g., 0 to 10 degrees) and may face each other. When the electronic device 200 is in the folded state (e.g., the state in FIG. 3), at least a portion of the folding area 231c may form a curved surface having a predetermined curvature.

In an embodiment, when the electronic device 200 is in the intermediate state, the first housing 210 and the second housing 220 may be disposed to form a predetermined angle of, for example, 90 degrees or 120 degrees. For example, in the intermediate state, the first display area 231a and the second display area 231b of the display 230 may form an angle larger than that in the folded state and smaller than that in the unfolded state. At least a portion of the folding area 231c may form a curved surface having a predetermined curvature, and the curvature in this case may be smaller than that in the folded state.

FIG. 4 is an exploded perspective view illustrating an electronic device 200 according to an embodiment of the disclosure.

Referring to FIG. 4, in an embodiment, the electronic device 200 may include a display 230, a support member assembly 260, at least one printed circuit board 270, a first housing 210, a second housing 220, a first rear surface cover 240, and a second rear surface cover 250. Herein, the display 230 may be referred to as a display module or a display assembly.

The configuration of the electronic device 200 of FIG. 4 may be entirely or partially identical to that of the electronic device 101 in FIG. 1 and/or the electronic device 200 in FIGS. 2 and 3. The configuration of the display 230 of FIG. 4 may be entirely or partially identical to that of the display module 160 of FIG. 1 and/or the display 230 of FIGS. 2 and 3.

The display 230 may include a display panel 231 (e.g., a flexible display panel), and at least one plate 232 or layer on which the display panel 231 is seated. In an embodiment, the plate 232 may be disposed between the display panel 231 and the support member assembly 260. The display panel 231 may be disposed on at least portion of one surface (e.g., the surface in the Z direction in FIG. 4) of the plate 232. The plate 232 may be formed in a shape corresponding to that of the display panel 231. For example, an area of the plate 232 may have a shape corresponding to that of the notch area 233 in the display panel 231.

The support member assembly 260 may include a first support member 261, a second support member 262, a hinge module 264 disposed between the first support member 261 and the second support member 262, a hinge cover 265 that covers the hinge module 264 when viewed from the outside, and a wiring member 263 (e.g., a flexible printed circuit board (FPCB)) extending across the first and second support members 261 and 262.

In an embodiment, the support member assembly 260 may be disposed between the plate 232 and at least one printed circuit board 270. For example, the first support member 261 may be disposed between the first display area 231a of the display 230 and a first printed circuit board 271. The second support member 262 may be disposed between the second display area 231b of the display 230 and a second printed circuit board 272.

In an embodiment, at least a portion of the wiring member 263 and the hinge module 264 may be disposed inside the support member assembly 260. The wiring member 263 may be disposed in a direction across the first support member 261 and the second support member 262 (e.g., the X-axis direction). The wiring member 263 may be disposed in a direction perpendicular to the folding axis (e.g., the Y-axis or the folding axis A in FIG. 2) of the folding area 231c (e.g., the X-axis direction).

In an embodiment, the hinge module 264 may include a hinge module 264a, a first hinge plate 264b, and/or a second hinge plate 264c. In some embodiments, the hinge module 264a may be interpreted as including the first hinge plate 264b and the second hinge plate 264c. In an embodiment, the first hinge plate 264b may be mounted inside the first housing 210, and the second hinge plate 264c may be mounted inside the second housing 220. In some embodiments, the first hinge plate 264b may be coupled to the first support member 261, and the second hinge plate 264c may be coupled to the second support member 262. In an embodiment, the first hinge plate 264b (or the second hinge plate 264c) may be coupled to another structure (e.g., a first rotation support surface 214 or a second rotation support surface 224) inside the first housing 210 (or the second housing 220). For example, the structure to which the first hinge plate 264b (or the second hinge plate 264c) is coupled inside the first housing 210 (or the second housing 220) may vary depending on the embodiment. In an embodiment, the hinge module 264a may be coupled to the first hinge plate 264b and the second hinge plate 264c to rotatably connect the second hinge plate 264c to the first hinge plate 264b. For example, a folding axis (e.g., the folding axis A in FIG. 2) is provided by the hinge module 264a, and the first housing 210 and the second housing 220 (or the first support member 261 and the second support member 262) may rotate substantially about the folding axis A relative to each other.

As described above, the at least one printed circuit board 270 may include the first printed circuit board 271 disposed on the first support member 261 side and the second printed circuit board 272 disposed on the second support member 262 side. The first printed circuit board 271 and the second printed circuit board 272 may be disposed in a space defined by the support member assembly 260, the first housing 210, the second housing 220, the first rear surface cover 240, and the second rear surface cover 250. Components for implementing various functions of the electronic device 200 may be mounted on the first printed circuit board 271 and the second printed circuit board 272.

In an embodiment, the first housing 210 and the second housing 220 may be assembled to be coupled to the opposite sides of the support member assembly 260 in the state in which the display 230 is coupled to the support member assembly 260. The first housing 210 and the second housing 220 may be slidably coupled to the opposite sides of the support member assembly 260, for example, to the first support member 261 and the second support member 262, respectively. The first support member 261 and the second support member 262 are substantially accommodated in the first housing 210 and the second housing 220, and may be interpreted as portions of the first housing 210 and the second housing 220, respectively, depending on the embodiment.

In an embodiment, the first housing 210 may include a first rotation support surface 214, and the second housing 220 may include a second rotation support surface 224, which corresponds to the first rotation support surface 214. The first rotation support surface 214 and the second rotation support surface 224 may include curved surfaces corresponding, respectively, to curved surfaces included in the hinge cover 265.

In an embodiment, when the electronic device 200 is in the unfolded state (e.g., the state of FIG. 2), the first rotation support surface 214 and the second rotation support surface 224 cover the hinge cover 265, so that the hinge cover 265 may not be exposed or may be minimally exposed to the rear surface of the electronic device 200. In an embodiment, when the electronic device 200 is in the folded state (e.g., the state of FIG. 3), the first rotation support surface 214 and the second rotation support surface 224 rotate, respectively, along the curved surfaces included in the hinge cover 265, so that the hinge cover 265 can be maximally exposed to the rear surface of the electronic device 200.

In the foregoing detailed description, in the first housing 210, the second housing 220, the first side member 213, the second side member 223, and the like, ordinal numbers are used merely to distinguish components. It is noted that various embodiments are not limited by the description of the ordinal numbers. For example, although the sensor area 231d is illustrated as being provided in the first housing 210, the sensor area 231d may be provided in the second housing 220 or may be provided in both the first and second housings 210 and 220. In an embodiment, a configuration in which the first rear surface area 241 and the sub-display 252 are disposed on the first rear surface cover 240 and the second rear surface cover 250, respectively, is exemplified, but both the first rear surface area 241 for disposing a sensor and the sub-display 252 for outputting a screen may be disposed on one of the first rear surface cover 240 and the second rear surface cover 250.

In an embodiment, the hinge module 264 may include a plurality of hinge modules arranged parallel to each other. For example, the hinge module 264 may include a first hinge module (not illustrated) and a second hinge module (not illustrated) that are symmetrical to each other with respect to the width direction of the electronic device 200 (e.g., the X-axis direction).

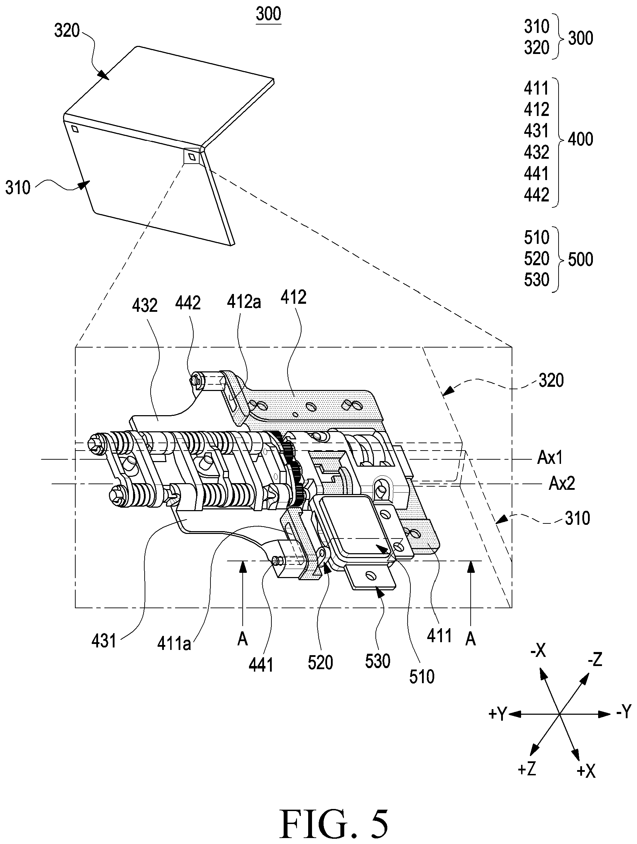

FIG. 5 is a view illustrating an internal structure and a foot assembly of the electronic device according to an embodiment of the disclosure.

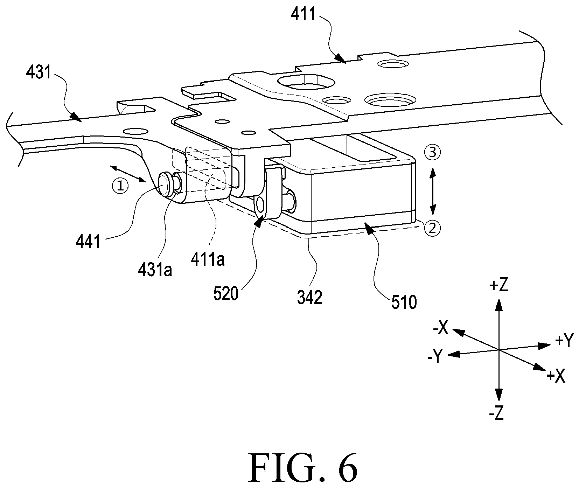

FIG. 6 is a view illustrating a part of the hinge module and the foot structure according to an embodiment of the disclosure.

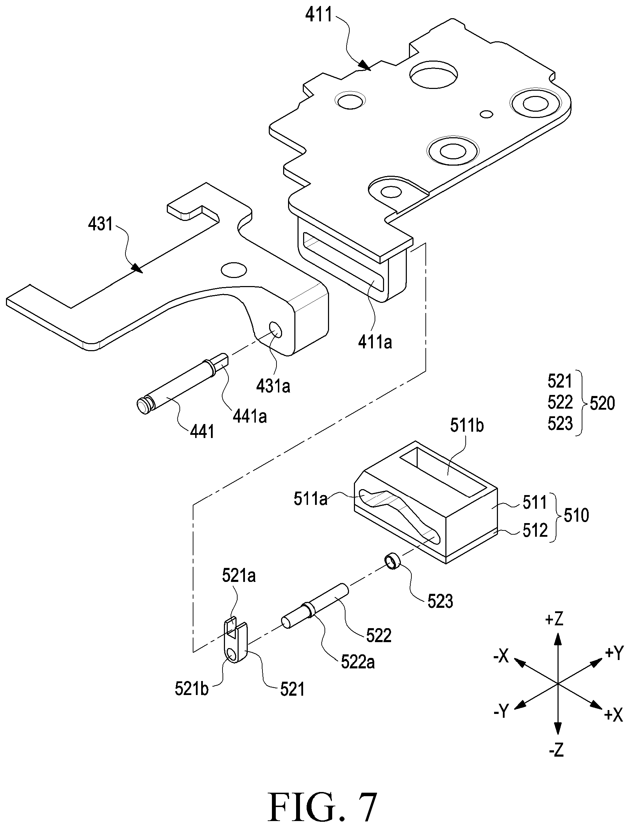

FIG. 7 is an exploded perspective view of a part of the hinge module, the link structure, and the foot structure according to an embodiment of the disclosure.

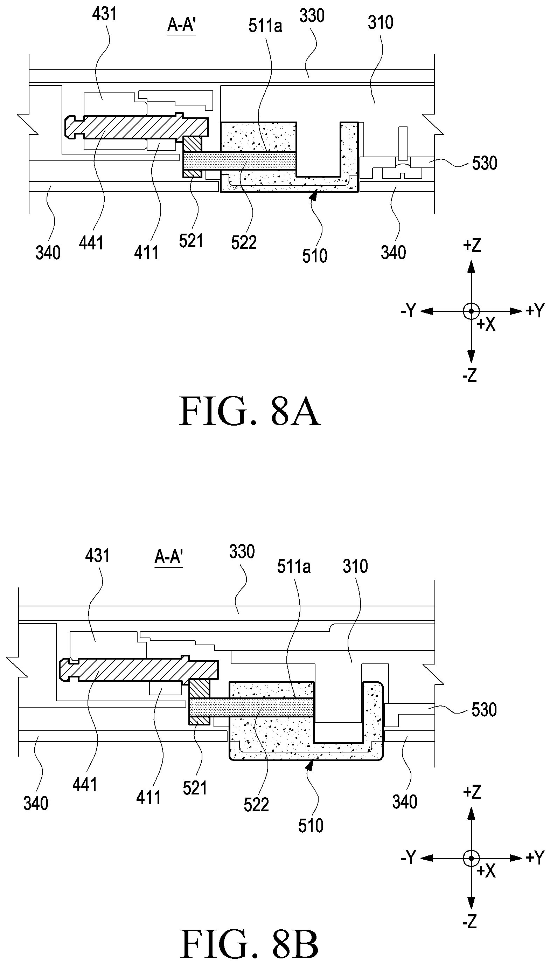

FIGS. 8A and 8B are views illustrating the operation of the foot structure according to various embodiments of the disclosure.

Referring to FIGS. 5 to 7, 8A, and 8B, in an embodiment, the electronic device 300 may include a first housing 310, a second housing 320, a display 330, a hinge module 400, and a foot assembly 500. The configuration of the electronic device 300 of FIG. 5 may be entirely or partially identical to that of the electronic device 101 of FIG. 1 and/or the electronic device 200 of FIGS. 2 to 4. The configurations of the first housing 310 and the second housing 320 of FIG. 5 may be entirely or partially identical to those of the first housing 210 and the second housing 220 of FIGS. 2 to 4, respectively. The configuration of the hinge module 400 of FIGS. 5 to 7, and 8A may be entirely or partially identical to that of the hinge module 264 of FIG. 4. The configuration of the display 330 of FIGS. 8A and 8B may be entirely or partially identical to that of the display 230 of FIGS. 2 to 4 (e.g., a flexible display or a foldable display). FIG. 5 may illustrate the appearances of the hinge module 400 and the foot structure 510 of FIG. 5 when the electronic device 300 is in the unfolded state.

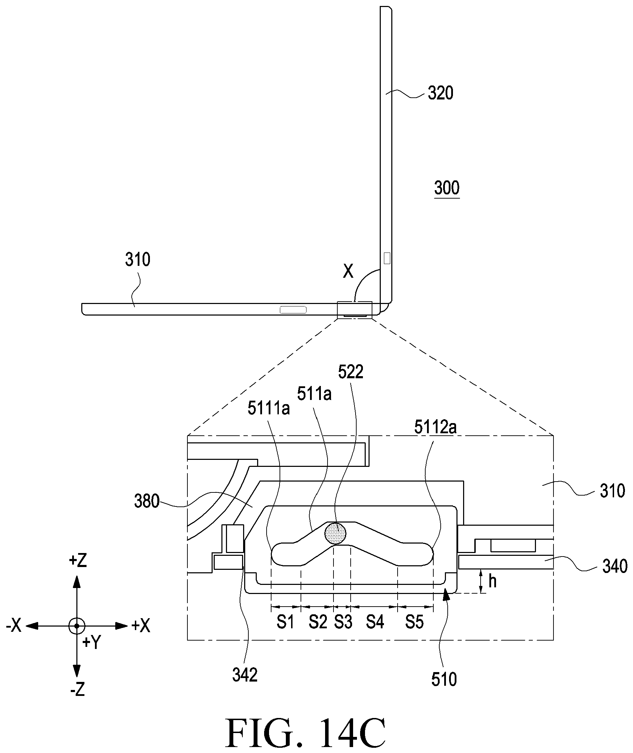

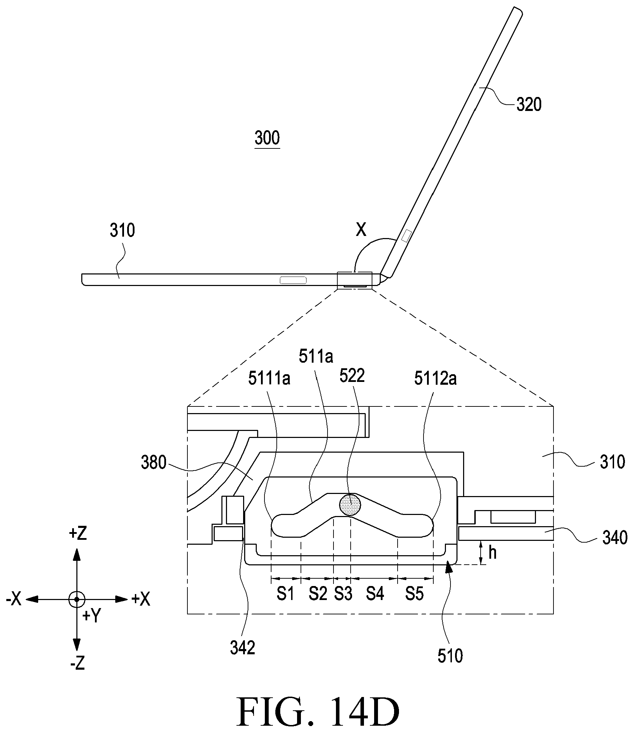

According to an embodiments disclosed herein, the electronic device 300 may be used in a laptop mode (e.g., the state illustrated in FIGS. 5, 14C, and 14D) in which the angle of the housing is adjusted to be placed on the ground such as a table. Herein, the "laptop mode" of the electronic device 300 may refer to a state in which the first housing 310 and the second housing 320 form a specific angle (e.g., about 90 degrees to about 120 degrees) among intermediate states of the electronic device 300.

Referring to FIGS. 5 to 7, in an embodiment, the hinge module 400 may be connected to the first housing 310 and the second housing 320. The first housing 310 may be rotated relative to the second housing 320 using the hinge module 400. In an embodiment, the hinge module 400 may include rotation members 411 and 412, arm members 431 and 432, and pin members 441 and 442.

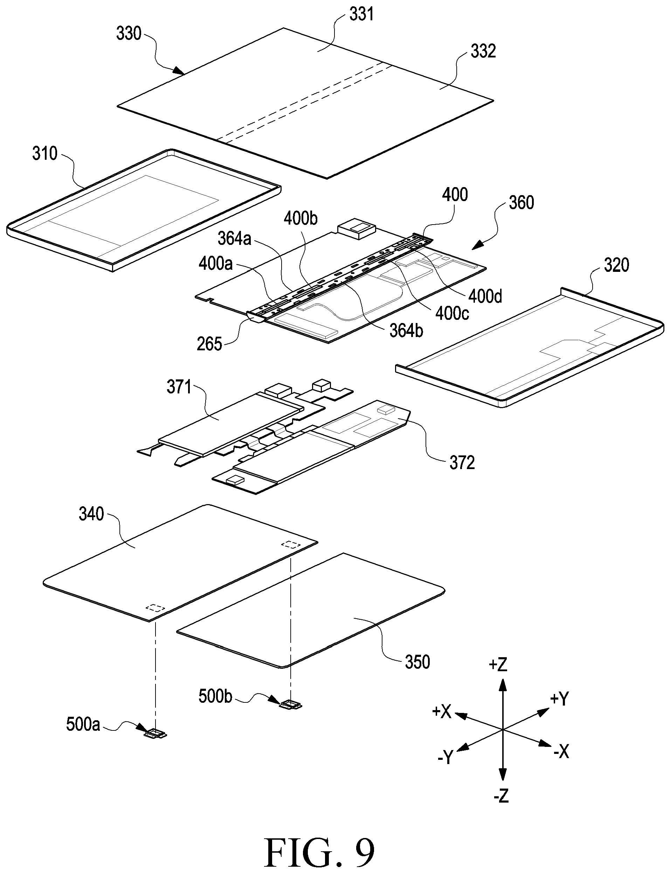

In an embodiment, the first rotation member 411 may be connected to the first housing 310. The second rotation member 412 may be connected to the second housing 320. In an embodiment, the first rotation member 411 may face at least a portion of the first display area (e.g., the first display area 231a in FIGS. 2 to 4 and/or the first display area 331 in FIG. 9), and the second rotation member 412 may face at least a portion of the second display area (e.g., the second display area 231b in FIGS. 2 to 4 and/or the second display area 332 in FIG. 9). In an embodiment, the rotation members 411 and 412 may substantially implement or guide the rotation of the first housing 310 and the second housing 320. In an embodiment, the first rotation member 411 may provide a first rotation axis Ax1, and the second rotation member may provide a second rotation axis Ax2. For example, the first housing 310 may rotate about the first rotation axis Ax1, and the second housing 320 may rotate about the second rotation axis Ax2. In an embodiment, the folding axis (e.g., the folding axis A in FIG. 2) may be interpreted as a virtual axis located between the first rotation axis Ax1 and the second rotation axis Ax2.

In an embodiment, the rotation members 411 and 412 may include pin slots 411a and 412a configured to accommodate the pin members 441 and 442, respectively. For example, the first rotation member 411 may include a first pin slot 411a in which a first pin member 441 is accommodated, and the second rotation member 412 may include a second pin slot 412a in which the second pin member 442 is accommodated. In an embodiment, the pin slots 411a and 412a may be holes or slots that penetrate in the length direction of the rotation members 411 and 412 (e.g., the Y-axis direction), and extend in the width direction (e.g., X-axis direction).

In an embodiment, the arm members 431 and 432 may position the first housing 310 and the second housing 320 at a certain angle. For example, the arm members 431 and 432 may prevent or reduce movement and/or rotation of the first housing 310 and/or the second housing 320 by providing force to the rotation members 411 and 412 in the length direction of the hinge module 400 (e.g., the Y-axis direction). For example, when a user applies external force greater than a predetermined value, the hinge module 400 may allow rotation of the first housing 310 and/or the second housing 320, and when no external force is applied or external force less than a predetermined value is applied, the arm members 431 and 432 may be used to maintain the first housing 310 and/or the second housing 320 in a stationary state.

In an embodiment, the arm members 431 and 432 may be connected to the pin members 441 and 442, respectively. For example, the first arm member 431 may include a first pin hole 431a that accommodates the first pin member 441. The second female member 432 may include a second pin hole 432a that accommodates the second pin member 442. The pin holes 431a and 432a may be grooves or holes. In an embodiment, the arm members 431 and 432 may be connected to the rotation members 411 and 412 using the pin members 441 and 442, respectively. For example, at least a portion of the first pin member 441 connected to the first arm member 431 may be accommodated within the first pin slot 411a of the first rotation member 411, and at least a portion of the second pin member 442 connected to the second arm member 432 may be accommodated within the second pin slot 412a of the second rotation member 412.

In an embodiment, the arm members 431 and 432 may slide relative to the rotation members 411 and 412. In an embodiment, the first pin member 441 connected to the first arm member 431 may slide within the first pin slot 411a in the direction indicated by arrow ① (the X-axis direction), and the second pin member 442 connected to the second arm member 432 may slide within the second pin slot 412a in the direction indicated by arrow ① (the X-axis direction).

In an embodiment, the hinge module 400 (e.g., the pin members 441 and 442) may transmit at least part of force applied to the first housing 310 to the second housing 320, or may transmit at least part of force applied to the second housing 320 to the first housing 310. For example, the hinge module 400 may transmit the rotation of the rotation members 411 and 412 to the arm members 431 and 432, or may transmit the rotation of the arm member 431 and 432 to the rotation members 411 and 412 using the pin members 441 and 442.

In an embodiment, one end of the first pin member 441 may be coupled to the first pin hole 431a of the first arm member 431. The other end of the first pin member 441 may be connected to be slidable within the first pin slot 411a of the first rotation member 411. In an embodiment, the second pin member 442 may be coupled to the second pin hole 432a of the second arm member 432. The other end of the second pin member 442 may be connected to be slidable within the second pin slot 412a of the second rotation member 412.

In an embodiment, the pin members 441 and 442 may be moved based on the rotation of the hinge module 400. For example, the pin members 441 and 442 may be moved together with the arm members 431 and 432 based on the rotation of the hinge module 400. For example, the first pin member 441 may slide in the direction indicated by arrow ① (the X-axis direction) within the first pin slot 411a. For example, the second pin member 442 may slide in the direction indicated by arrow ① (the X-axis direction) within the second pin slot 412a. In an embodiment, the end of the first pin member 441, which is connected to the first pin slot 411a, may include a link connection portion 441a connected to a first link member (e.g., the first link hole 521a of the first link member 521 in FIG. 7).

Referring again to FIG. 5, in an embodiment, the foot assembly 500 may be disposed in the first housing 310. FIG. 5 may illustrate the appearance of the electronic device 300 when viewing the second surface (e.g., the second surface 212 in FIGS. 2 to 4) which is the rear surface of the first housing 310. For example, at least a portion of the foot assembly 500 may be accommodated in the internal space of the first housing 310. For example, at least a portion of the foot assembly 500 may be disposed between the hinge module 400 and the second surface (e.g., the second surface 212 of FIGS. 2 to 4) of the first housing 310. However, the position of the foot assembly 500 is not limited to the above-mentioned area of the first housing 310. For example, at least one foot assembly 500 may be positioned in any area adjacent to the outer surface of the first housing 310 and/or the second housing 320.

Referring to FIG. 5, in an embodiment, the foot assembly 500 may be disposed below the hinge module 400 (in the -Z direction). For example, the foot assembly 500 may be closer to the first rotation member 411 than to the first arm member 431. For example, when viewed in the -Z direction, the foot assembly 500 and the first rotation member 411 may at least partially overlap.

Referring to FIGS. 5 to 7, in an embodiment, the foot assembly 500 may include a foot structure 510, a link structure 520, and a foot structure holder 530.

Referring to FIGS. 6 and 7, in an embodiment, the foot structure 510 may include a first member 511, a second member 512, a guide slot 511a, and a mounting groove 511b. In an embodiment, the foot structure 510 may raise a portion of the electronic device 300 from the ground when the electronic device 300 is placed on the ground. For example, the second member 512 may be in contact with the ground and support the electronic device 300. In an embodiment, the second member 512 of the foot structure 510 may extend from the first member 511 to the exterior of the first housing 310 (in the -Z direction). In an embodiment, the second member 512 may have a portion that is in contact with the ground (e.g., a -Z direction surface). The second member 512 may prevent slippage of the first housing 310 relative to the ground. For example, a friction coefficient of the second member 512 may be greater than a friction coefficient of the first housing 310. For example, a friction coefficient of the second member 512 may be greater than a friction coefficient of the first member 511. For example, the second member 512 may include rubber. In an embodiment, the first member 511 and the second member 512 may be formed separately and coupled to each other. In an embodiment, the first member 511 and the second member 512 may be formed integrally. For example, the first member 511 and the second member 512 may be formed by double injection molding.

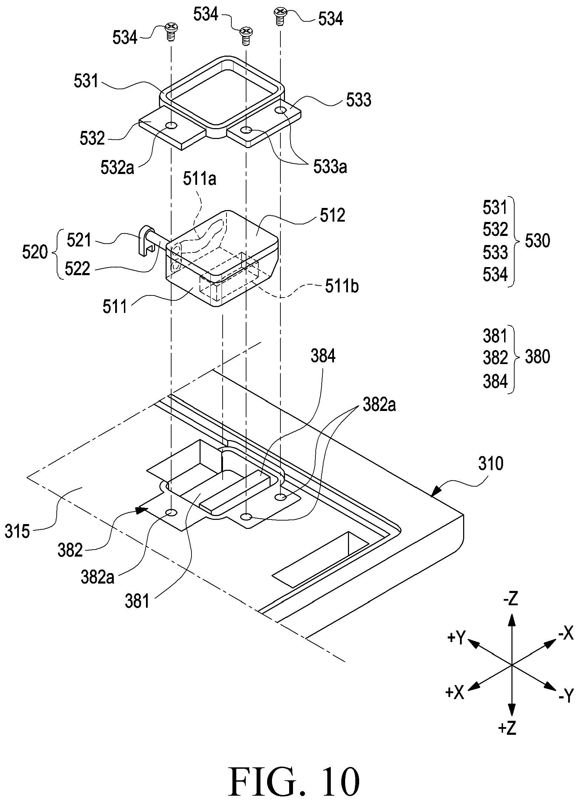

In an embodiment, the guide slot 511a may be formed in a portion of the first member 511. For example, the guide slot 511a may be formed in a portion of the side wall facing the link member of the first member 511 (e.g., the side wall in the -Y direction). For example, the guide slot 511a may be a hole or slot that penetrates in the thickness direction (e.g., the Y-axis direction) of the side wall of the first member 511 and extends in the length direction (e.g., the X-axis direction). In an embodiment, the guide slot 511a may include at least one straight-line slot and/or at least one diagonal slot. In an embodiment, the mounting groove 511b may be formed in a portion of the first member. For example, the mounting groove 511b may be formed in a portion of the upper wall (e.g., the wall in the +Z direction) facing the recess 380 (e.g., the recess 380 in FIG. 10) of the first housing. For example, the mounting groove may be a groove or recess that is recessed into the interior of the first member 511 from the upper wall (e.g., in the -Z direction). For example, the mounting groove 511b may accommodate at least a portion of a protrusion 384 (e.g., the protrusion 384 in FIG. 10) of the recess 380 (e.g., the recess 380 in FIG. 10). For example, the mounting groove 511b may be shaped to engage with the protrusion 384 (e.g., the protrusion 384 in FIG. 10).

In an embodiment, the link structure 520 may include a first link member 521, a second link member 522, a first fixing ring 522a, and a second fixing ring 523. In an embodiment, the first link member 521 may be connected to the second link member 522 and the first pin member 441 of the hinge module 400. In an embodiment, the first link member 521 may include a first link hole 521a. For example, at least a portion of the link connection portion 441a of the first pin member 441 may be accommodated in the first link hole 521a. The link structure 520 may be connected to the first arm member 431 and the first rotation member 411 using the first pin member 441. For example, the first link hole 521a may be a slot or recess that penetrates in the width direction of the first link member 521 (the Y-axis direction) and opens in the length direction (the Z-axis direction). In an embodiment, the first link member 521 may include a second link hole 521b to which the second link member 522 is connected. For example, the second link hole 521b may be a hole that accommodates one end of the second link member 522. For example, the second link hole 521b may be a hole that penetrates in the width direction of the first link member 521 (the Y-axis direction). For example, the second link hole 521b may be spaced apart from the first link hole 521a in one direction (e.g., the -Z direction).

In an embodiment, the second link member 522 may be connected to the first link member 521 and the foot structure 510. For example, one end of the second link member 522 may be connected to the second link hole 521b, and the other end of the second link member 522 may be connected to the guide slot 511a. In an embodiment, the second link member 522 may be at least partially accommodated within the guide slot 511a. In an embodiment, the first fixed ring 522a and the second fixed ring 523 may couple the second link member 522 to the guide slot 511a. For example, the first fixed ring 522a and the second fixed ring 523 may support the second link member 522 inserted into the guide slot 511a inside and outside the foot structure 510. For example, the first fixed ring 522a may be located outside the foot structure 510. The second fixed ring 523 may be located inside the foot structure 510. For example, the first fixed ring 522a may be mounted around the second link member 522 and located adjacent to the end or opening of the guide slot 511a in the -Y direction. The second fixed ring 523 may be mounted around the second link member 522 and located adjacent to the end or opening of the guide slot 511a in the +Y direction. The first fixed ring 522a and the second fixed ring 523 may prevent the second link member 522 connected to the guide slot 511a from disengaging.

In an embodiment, the link structure 520 and the foot structure 510 may move based on the rotation of the hinge module 400. For example, the link structure 520 may receive the rotational force of the hinge module 400 through the first link member 521 coupled to the first pin member 441. For example, the link structure 520 may move substantially together with the first pin member 441. For example, the link structure 520 may move in the direction indicated by arrow ① (the X-axis direction) relative to the first rotation member 411 based on the rotation of the hinge module 400.

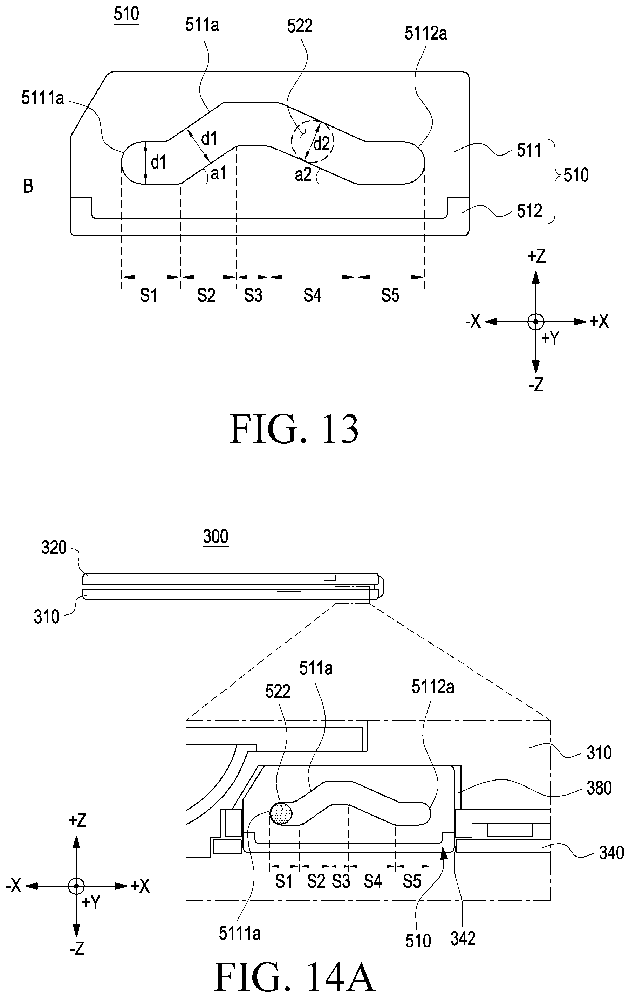

In an embodiment, the foot structure 510 may move in the Z-axis direction based on the rotation of the hinge module 400. In an embodiment, the link structure 520 may transmit the rotational force of the hinge module 400 to the foot structure 510 via the second link member 522 connected to the guide slot 511a. According to an embodiment, the second link member 522 may move along the guide slot 511a based on the rotation of the hinge module 400. In an embodiment, the second link member 522 can move linearly in one direction (e.g., the X-axis direction) without changing the position on the Z-axis within the guide slot 511a. The foot structure 510 may move linearly in one direction (e.g., the Z-axis direction) relative to the first housing 310 based on the movement of the second link member 522. For example, the foot structure 510 may move in the Z-axis direction due to the shape of the guide slot 511a including a diagonal section forming an angle with respect to the Z-axis. For example, the foot structure 510 may move toward the direction indicated by the arrow ② direction (the -Z direction) (or the exterior of the housing 310). For example, the foot structure 510 may move toward the direction indicated by arrow ③ (the +Z direction) (or the interior of the first housing 310). In an embodiment, the foot structure 510 may move toward the interior or the exterior of the first housing 310 through the through hole 342 (e.g., the through hole 342 in FIG. 6 and FIGS. 14A to 14F) of the first rear surface cover 340 (e.g., the first rear surface cover 240 in FIGS. 2 to 4 and/or the first rear surface cover 340 in FIG. 9) disposed on the second surface (e.g., the second surface (212) of FIGS. 2 to 4) of the first housing 310.

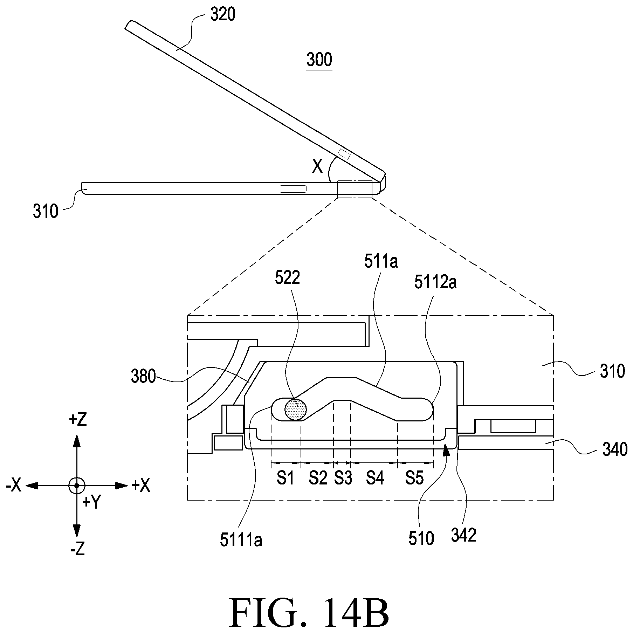

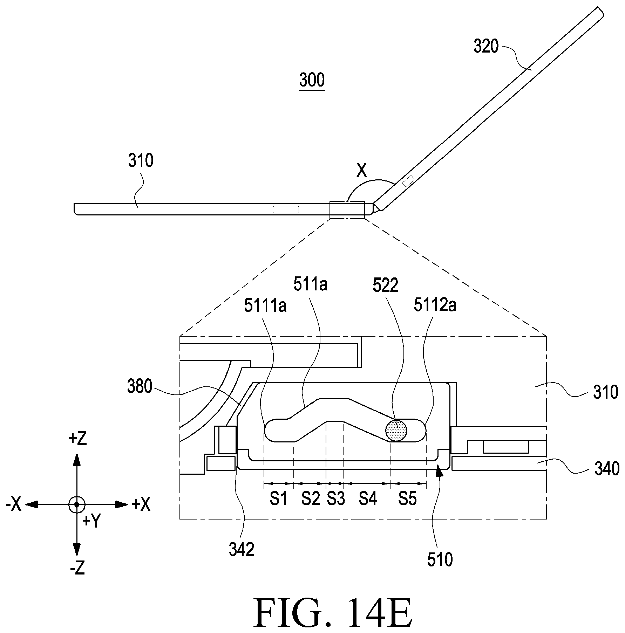

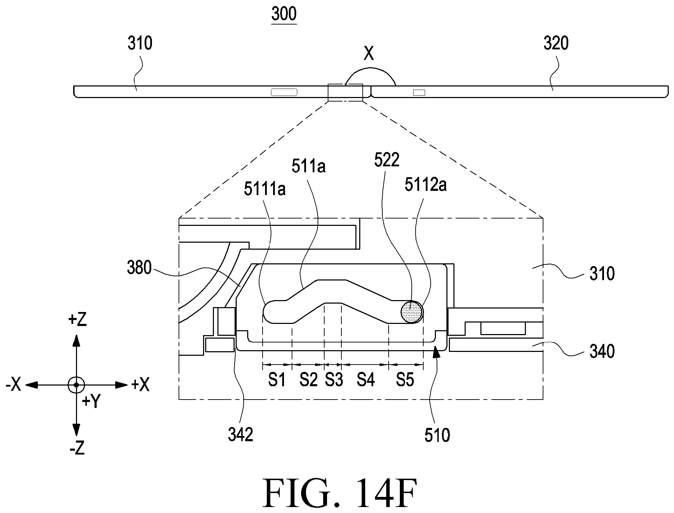

FIGS. 8A and 8B are cross-sectional views taken along line A-A' in FIG. 5. In an embodiment, the foot structure 510 may be positioned in a first state (e.g., the state illustrated in FIGS. 8A, 14A, 14B, 14E, and 14F) accommodated in the interior (e.g., a recess) of the first housing 310. In an embodiment, the foot structure 510 may be positioned in a second state (e.g., the state illustrated in FIGS. 8B, 14C, and 14D) where it protrudes maximally outward from the first housing 310. In an embodiment, the foot structure 510 may be positioned in a third state (not illustrated) that is intermediate between the first state and the second state. According to an embodiment disclosed herein, the foot structure 510 may be accommodated within the interior of the electronic device when it is not needed (e.g., the closed state and the unfolded state of the electronic device 300). By using the foot structure 510 according to an embodiment, the usability and appearance of the electronic device 300 may be improved compared to the case where the foot structure is a fixed type that is always protruding. For example, when the foot structure 510 is accommodated while the electronic device 300 is unfolded, the display 330 disposed on the front surface may become flatter when placed on the ground in the unfolded state, compared to the fixed-type foot structure. For example, when the foot structure 510 is accommodated while the electronic device 300 is closed, the appearance of the electronic device 300 can be improved when carried or stored, compared to the fixed-type foot structure.

In an embodiment, the foot structure 510 may be switched between the first state and the third state in response to the rotation of the hinge module 400 or the unfolding and closing operation of the electronic device 300. For example, when the electronic device 300 is switched from the closed state (e.g., the state illustrated in FIG. 3 and/or FIG. 14A) to a laptop mode (e.g., the state illustrated in FIGS. 14C and 14D), the foot structure 510 may be switched from the first state to the second state through the third state. For example, when the electronic device 300 is switched from the laptop mode (e.g., the state illustrated in FIGS. 14C and 14D) to the unfolded state (e.g., the state illustrated in FIG. 2 and/or FIG. 14F), the foot structure 510 may be switched from the second state to the first state through the third state.

In an embodiment, the foot structure 510 may protrude outward from the first housing 310 by a protrusion distance h. For example, the protrusion distance h may be a distance that the foot structure 510 protrudes in the -Z direction from the outer surface (the surface in the -Z direction) of the first rear surface cover 340 (e.g., the first rear surface cover 240 in FIGS. 2 to 4 and/or the first rear surface cover 340 in FIG. 9). For example, the protrusion distance h may be greater than 0 and smaller than the first distance. For example, the first distance may be about 1 mm. For example, when the foot structure 510 is in the first state (the state illustrated in FIG. 8A), the protrusion distance h may be 0. For example, when the foot structure 510 is in the second state (the state illustrated in FIG. 8B), the protrusion distance h may substantially correspond to a first predetermined distance (e.g., 1 mm). For example, when the foot structure 510 is in the third state (not illustrated) that is intermediate between the first state and the second state, the protrusion distance h may be greater than 0 and smaller than the first distance.

FIG. 9 is an exploded perspective view illustrating the electronic device according to an embodiment of the disclosure.

FIG. 10 is a view illustrating a structure in which a foot structure is mounted on an electronic device according to an embodiment of the disclosure.

Referring to FIG. 9, in an embodiment, the electronic device 300 may include a first housing 310, a second housing 320, a display 330, a support member assembly 360, a first printed circuit board 371, a second printed circuit board 372, a foot assembly 500, a first rear surface cover 340, and a second rear surface cover 350.

The configuration of the first housing 310 of FIGS. 9 and 10 may be entirely or partially identical to that of the first housing 310 of FIGS. 5, 8A, and 8B. The configuration of the second housing 320 of FIG. 9 may be entirely or partially identical to that of the second housing 320 of FIGS. 5, 8A, and 8B. The configuration of the display 330 of FIG. 9 may be entirely or partially identical to that of the display 330 of FIGS. 8A and 8B. The configuration of the support member assembly 360 of FIG. 9 may be entirely or partially identical to that of the support member assembly 260 of FIG. 4. The configurations of the first printed circuit board 371 and the second printed circuit board 372 of FIG. 9 may be entirely or partially identical to those of the first printed circuit board 271 and the second printed circuit board 272 of FIG. 4, respectively. The configurations of the first rear surface cover 340 and the second rear surface cover 350 of FIG. 9 may be entirely or partially identical to those of the first rear surface cover 240 and the second rear surface cover 250 of FIGS. 2 to 4, respectively. The configuration of the foot assembly 500 of FIG. 9 may be entirely or partially identical to that of the foot assembly 500 of FIG. 5. The configurations of the foot structure 510, the link structure 520, and the foot structure holder 530 of FIG. 10 may be entirely or partially identical to those of the foot structure 510, the link structure 520, and the foot structure holder 530 of FIGS. 5 to 7, 8A, and 8B, respectively. The configuration of the foot structure holder 530 of FIG. 10 may be entirely or partially identical to that of the foot structure holder 530 of FIG. 5.

In an embodiment, the support member assembly 360 may include a first hinge plate 364a (e.g., the first hinge plate 264b in FIG. 4) connected to the first housing 310, a second hinge plate 364b (e.g., the second hinge plate 264c in FIG. 4) connected to the second housing 320, and a hinge module 400 (e.g., the hinge module 400 in FIG. 5).

In an embodiment, the hinge module 400 may include a plurality of hinge modules 400a, 400b, 400c, and 400d. For example, referring to FIG. 9, the hinge module 400 may include a first hinge module 400a, a second hinge module 400b, a third hinge module 400c, and a fourth hinge module 400d arranged in a parallel manner in the Y-axis direction. For example, the configurations of the first hinge module 400a and the second hinge module 400b may be substantially identical to each other. For example, the configurations of the third hinge module 400c and the fourth hinge module 400d may be substantially identical to each other. For example, the first hinge module 400a may be a mirror image of the third hinge module 400c and the fourth hinge module 400d. For example, the second hinge module 400b may be a mirror image of the third hinge module 400c and the fourth hinge module 400d.

In an embodiment, the foot assembly 500 may include a plurality of foot assemblies 500a and 500b. For example, the foot assembly 500 may include a first foot assembly 500a and a second foot assembly 500b that is arranged parallel to the first foot assembly 500a in the Y-axis direction. For example, the first foot assembly 500a and the second foot assembly 500b may be mirror images of each other. In an embodiment, the first foot assembly 500a and the second foot assembly 500b may each be connected to one or more hinge modules 400a, 400b, 400c, and 400d. For example, the first foot assembly 500a may be connected to the first hinge module 400a. For example, the second foot assembly 500b may be connected to the fourth hinge module 400d. However, the connection between the foot structure 510 and the hinge module is not limited to a one-to-one connection. In an embodiment, a plurality of foot assemblies 500 may be connected to a single hinge module 400. In an embodiment, a single foot assembly 500 may be connected to a plurality of hinge modules 400.

Referring to FIG. 10, in an embodiment, an electronic device 300 (e.g., the first housing 310) may include a cover mounting portion 315 that accommodates the first rear surface cover 340. For example, the cover mounting portion 315 may be a recessed portion of a portion of the second surface (e.g., the second surface 212 in FIGS. 2 to 4) of the first housing 310. For example, with respect to the Z axis, the depth of the cover mounting portion 315 may be substantially equal to the thickness of the first rear surface cover 340. For example, the first rear surface cover 340 may be mounted on the cover mounting portion 315 to form a single connected surface with the first housing 310. For example, the first rear surface cover 340 coupled to the cover mounting portion 315 may be spaced apart from the inner surface of the first housing 310.

Referring to FIG. 10, in an embodiment, the foot structure holder 530 may be connected to the foot structure 510 and the first housing 310. In an embodiment, the foot structure holder 530 may include a holder portion 531 and one or more wing portions 532 and 333. In an embodiment, the holder portion 531 may be shaped to wrap a portion of the foot structure 510 in a lateral direction (the X direction and/or the Y direction). For example, the holder portion 531 may include a hole having a shape corresponding to the foot structure 510. For example, the holder portion 531 may be a square ring member. For example, the holder portion 531 may support the foot structure 510 in a lateral direction (the X direction and/or the Y direction). According to an embodiment, the wing portions may include a first wing portion 532 extending from the holder portion 531 in the X direction and a second wing portion 533 extending in the Y direction. For example, with respect to the foot structure holder 530 illustrated in FIG. 10, the first wing portion 532 may extend in the +X direction and the second wing portion 533 may extend in the -Y direction. In an embodiment, the first wing portion 532 and the second wing portion 533 may each include at least one first fastening hole 532a or 533a in which a fastening member 534 is accommodated. For example, the at least one fastening member 534 may pass through the first fastening hole 532a or 533a and be coupled to the first housing 310. For example, the fastening member 534 may be viewed as being included in the foot structure holder 530. For example, the fastening member 534 may be a screw member or a boss member. For example, the foot structure holder 530 may guide the foot structure 510 to prevent it from moving in the forward-rearward direction (the X-axis direction) and/or the left-right direction (the Y-axis direction) when the foot structure 510 moves in the Z-axis direction. However, the connection structure of the foot structure holder 530 to the first housing 310 is not limited to the above-described content, and for example, the foot structure holder 530 may be connected to the first housing 310 by various connecting means (e.g., rivets) including screws. As an example, the foot structure holder 530 may be bonded to the first housing 310 by adhesive means (e.g., adhesive or tape) provided on one surface of the foot structure holder 530. In an embodiment, the foot structure holder 530 may be directly connected to the first housing 310 without a separate member. In an embodiment, the foot structure holder 530 may be directly connected to the first housing 310 without a separate member (e.g., the foot structure holder 530). For example, the foot structure 510 and/or the foot structure holder 530 may be mechanically coupled (e.g., snap-fit-coupled) to the first housing 310.

In an embodiment, the first housing 310 may include a recess 380 that accommodates the foot structure 510 and the foot structure holder 530. In an embodiment, the recess 380 may include a first recess 381 that accommodates the foot structure 510, a second recess 382 that accommodates the foot structure holder 530, and a protrusion 384. In an embodiment, the first recess 381 may be formed in an area on the first housing 310 (e.g., the cover mounting portion 315) where the foot structure 510 is positioned. For example, the first recess 381 may be a concave portion formed to accommodate at least a portion of the foot structure 510. In an embodiment, the first rear surface cover 340 may include a through hole 342 (e.g., the through hole 342 in FIG. 6 and/or FIGS. 14A to 14F). For example, the through hole 342 may be formed at a position corresponding to the first recess 381. For example, the shape of the through hole 342 may be an opening through which the foot structure 510 is capable of passing in the Z-axis direction. For example, the through hole 342 and the first recess 381 may be at least partially connected. For example, the foot structure 510 may have at least a portion (e.g., the second member 512) exposed through the through hole 342 when mounted in the first recess 381. For example, the foot structure 510 may move in the Z-axis direction through the first recess 381 and/or the through hole 342.

In an embodiment, the protrusion 384 may extend outward (in the -Z direction) from one surface (the surface in the -Z direction) of the first recess 381. In an embodiment, the protrusion 384 may be inserted into or withdrawn from the mounting groove 511b of the foot structure 510 (e.g., the first member 511). For example, the protrusion 384 can be shaped to engage with the mounting groove 511b. For example, the shape of the cross-section (e.g., cross-section along the XY plane) of the protrusion 384 may correspond to the shape of the mounting groove 511b. For example, the protrusion 384 may have various shapes such as a cylinder or a square pillar. For example, with respect to the Z axis, the height of the protrusion 384 may be smaller than or equal to the depth of the mounting groove 511b. For example, the protrusion 384 may guide the installation position and/or installation direction of the foot structure 510 when the foot structure 510 is installed in the first recess 381. For example, the protrusion 384 may guide the movement of the foot structure 510 in the Z axis direction. For example, the protrusion 384 may support the foot structure 510 to prevent the foot structure from moving in the forward-rearward direction (the X-axis direction) and/or the left-right direction (the Y-axis direction) when moving in the Z-axis direction. In an embodiment, the first recess 381 may open in a direction in which the link structure 520 connected to the foot structure 510 is positioned (e.g., the -Y direction). For example, the first recess 381 may be connected to the hinge module 400 disposed in the inner space of the first housing 310 through the open area. For example, the link structure 520 may be arranged to cross the open area. For example, at least a portion of the link structure 520 may be arranged on the first recess 381.

In an embodiment, the second recess 382 may be a recess formed in the first housing 310 (e.g., the cover mounting portion 315). For example, with respect to the Z axis, the depth of the second recess 382 may be smaller than the depth of the first recess 381. For example, the shape of the second recess 382 may be capable of accommodating at least a portion of the foot structure holder 530. For example, the second recess 382 may be shaped to engage with the foot structure holder 530. For example, the second recess 382 may include a plurality of concave portions that accommodate the holder portion 531 and the wing portions 532 and 533 of the foot structure holder 530. In an embodiment, the second recess 382 may include one or more second fastening holes 382a that accommodates the fastening members 534. For example, the second fastening holes 382a may be formed at positions corresponding to the first fastening holes 532a and 533a of the foot structure holder 530 of the second recess 382. For example, the inner surfaces of one or more second fastening holes 382a may include screw threads.

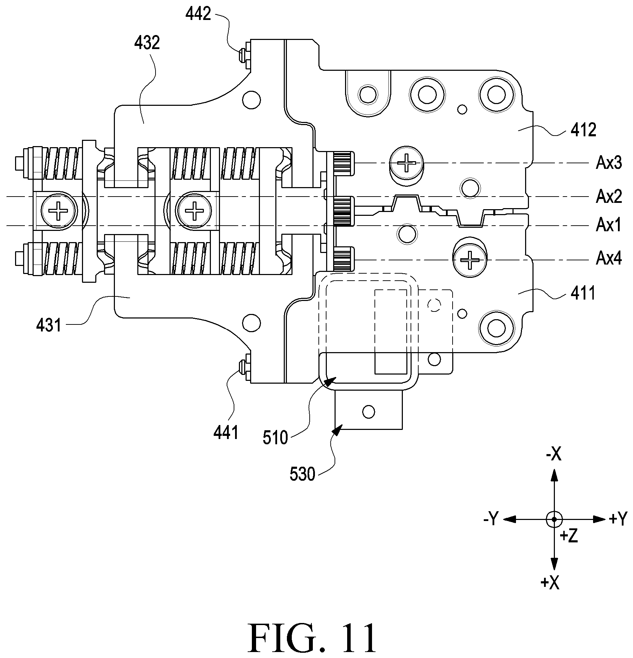

FIG. 11 is a plan view of a hinge module and a foot assembly 500 according to an embodiment of the disclosure.

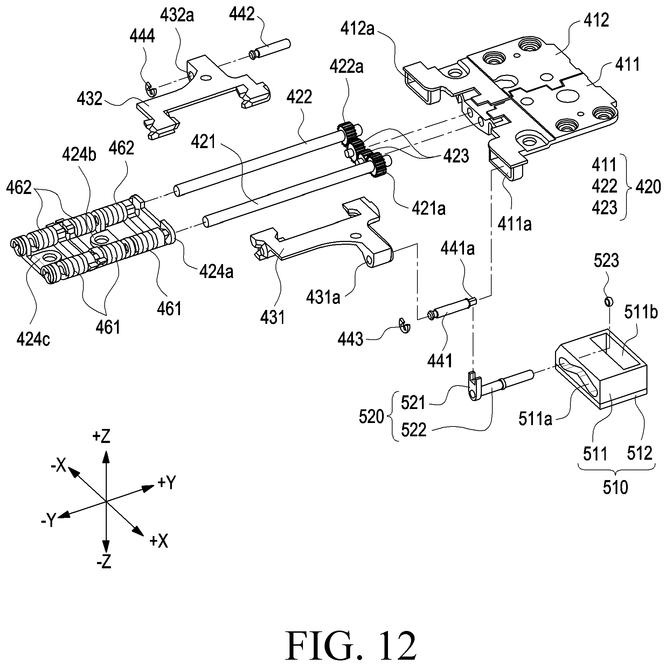

FIG. 12 is an exploded perspective view of a hinge module, a link structure, and a foot structure according to an embodiment of the disclosure.

Referring to FIGS. 11 and 12, in an embodiment, the hinge module 400 may include rotation members 411 and 412, a linkage structure 420, arm members 431 and 432, pin members 441 and 442, and elastic members 461 and 462. The configuration of the hinge module 400 of FIGS. 11 and 12 may be entirely or partially identical to that of the hinge module 400 of FIG. 5 and/or FIG. 9. The configuration of the foot structure 510 of FIGS. 11 and 12 may be entirely or partially identical to that of the foot structure 510 of FIGS. 9 and 10. The configuration of the link structure 520 of FIG. 12 may be entirely or partially identical to that of the link structure 520 of FIGS. 9 and 10. The configuration of the foot structure holder 530 of FIG. 11 may be entirely or partially identical to that of the foot structure holder 530 of FIG. 10.

In an embodiment, the hinge module 400 (e.g., the linkage structure 420) may include gear shafts 421 and 422, an idle gear 423, and gear shaft support members 424a, 424b, and 424c. In an embodiment, the linkage structure 420 may link the rotation of the first housing 310 (e.g., the first housing 310 in FIG. 9) with the rotation of the second housing 320 (e.g., the second housing 320 in FIG. 9). In an embodiment, the linkage structure 420 may use gears (e.g., the first gear shaft 421, the second gear shaft 422, and/or the idle gear 423) to rotate the second housing 320 by substantially the same angle as the angle by which the first housing 310 is rotated.

In an embodiment, the gear shafts 421 and 422 may include a first gear shaft 421 that is rotatable about a first linkage axis Ax3, and a second gear shaft 422 that is rotatable about a second linkage axis Ax4. In an embodiment, the first gear 421a of the first gear shaft 421 and the second gear 422a of the second gear shaft 422 may mesh with each other to link the first housing 310 (e.g., the first housing 310 in FIG. 9) and the second housing 320 (e.g., the second housing 320 in FIG. 9). For example, the force transmitted from the first rotation member 411 coupled to the first housing 310 may be transmitted to the first gear shaft 421 through the first arm member 431. The first gear shaft 421 may mesh with the second gear shaft 422, and the second gear shaft 422 may rotate in a direction different from the rotation direction of the first gear shaft 421. The force transmitted to the second gear shaft 422 may be transmitted to the second arm member 432 and/or the second housing 320. In an embodiment, ends of the gear shafts 421 and 422 can be connected to the rotation members 411 and 412.

In an embodiment, the gear shaft support members 424a, 424b, and 424c may include one or more holes that accommodate the gear shafts 421 and 422 and/or the idle gear 423. For example, the gear shaft support members 424a, 424b, and 424c may prevent or reduce the disengagement of the gear shafts 421 and 422 and/or the idle gear 423. In an embodiment, the gear shaft support members 424a, 424b, and 424c may include a plurality of gear shaft support members (e.g., a first gear shaft support member 424a, a second gear shaft support member 424b, and a third gear shaft support member 424c) arranged in the length direction of the hinge module 400 (e.g., the Y-axis direction).

In an embodiment, the linkage structure 420 may include a gear cover (not illustrated) that protects the first gear shaft 421 and/or the second gear shaft 422 from an external impact. The gear cover (not illustrated) may surround at least a portion of the first gear 421a, the second gear 422a, and/or the idle gear 423.

In an embodiment, the first arm member 431 may rotate around the first linkage axis Ax3 together with the first gear shaft 421, and the second arm member 432 may rotate around the second linkage axis Ax4 together with the second gear shaft 422. The rotational axes Ax1 and Ax2 and the linkage axes Ax3 and Ax4 of the gear shafts 421 and 422 may be different. For example, the first rotation axis Ax1, the second rotation axis Ax2, the first linkage axis Ax3, and the second linkage axis Ax4 may be substantially parallel.

In an embodiment, the first elastic member 461 may be connected to the first gear shaft 421. The second elastic member 462 may be connected to the second gear shaft 422. In an embodiment, the first elastic member 461 and/or the second elastic member 462 may each include a plurality of elastic members that are parallel to the Y axis. For example, the first elastic member 461 and/or the second elastic member 462 may include a spring. In an embodiment, the first and second elastic members 461 and 462 may provide elastic force in the length direction of the hinge module 400 (e.g., the Y-axis direction). For example, the first and second elastic members 461 and 462 may come into contact with a portion of the arm members 431 and 432 to provide elastic force. For example, the first and second elastic members 461 and 462 and the arm members 431 and 432 may each include a cam member (not illustrated), and the first and second elastic members 461 and 462 may transmit elastic force by utilizing contact between the cam members.

In an embodiment, the hinge module 400 (e.g., a torque transmission structure 440) may include a first fixing clip 443 connected to one end of the first pin member 441 and a second fixing clip 444 connected to one end of the second pin member 442. In an embodiment, the fixing clips 443 and 444 may prevent or reduce disengagement of the pin members 441 and 442.

FIG. 13 is a view illustrating a guide slot of a foot structure according to an embodiment of the disclosure.

FIGS. 14A to 14F are views illustrating a link structure and a foot structure that move based on an angle between a first housing and a second housing according to various embodiments of the disclosure.

Referring to FIGS. 14A to 14F, an electronic device 300 may include a first housing 310, a second housing 320, and a foot structure 510. The configuration of the electronic device 300 of FIGS. 14A to 14F may be entirely or partially identical to that of the electronic device 300 of FIG. 5. The configurations of the first housing 310 and the second housing 320 of FIGS. 14A to 14F may be entirely or partially identical to those of the first housing 310 and the second housing 320 of FIG. 9. The configurations of the foot structure 510 and the link structure 520 of FIGS. 13 and 14A to 14F may be entirely or partially identical to those of the foot structure 510 and the link structure 520 of FIGS. 11 and 12.

Referring to FIG. 13, in an embodiment, the guide slot 511a may be a slot that penetrates in the thickness direction (the Y-axis direction) of the side wall facing the link structure 520 of the first member 511. In an embodiment, the guide slot 511a may include a pair of closed ends, i.e., a first slot end 5111a and a second slot end 5112a. For example, the first slot end 5111a may be closer to the folding axis (e.g., the folding axis A of FIG. 2) than the second slot end 5112a. For example, the guide slot 511a may extend between the pair of closed ends. In an embodiment, the guide slot 511a may include at least one straight-line slot and/or at least one diagonal slot. In an embodiment, the guide slot 511a may include a first section S1, a second section S2, a third section S3, a fourth section S4 connected to the first slot end 5111a, and a fifth section S5 connected to the second slot end 5112a. For example, the first to fifth sections S1 to S5 may be slots that are sequentially connected in the +X direction. For example, the height d1 of the guide slot 511a, which is a straight-line distance of each section, may be constant in the first to fifth sections S5. For example, the diameter d2 of the second link member 522 may be less than or equal to the height d1 of the guide slot 511a.

In an embodiment, the first section S1 may include a straight-line slot that extends from the first slot end 5111a in the +X direction. In an embodiment, the second segment S2 may include a diagonal slot extending from an end connected to the opposite end of the first slot end 5111a of the first segment S1 at an angle a1 with respect to a phantom line B. For example, the phantom line B may be substantially parallel to the X-axis. In an embodiment, the third segment S3 may include a straight-line slot extending from an end connected to the other end of the second segment S2 in the +X direction. In an embodiment, the fourth segment S4 may include a diagonal slot extending from an end connected to the other end of the third segment S3 at an angle a2 with respect to the phantom line B. For example, the fifth segment S5 may include a straight-line segment extending from an end connected to the other end of the fourth segment S4 in the +X direction. For example, the first segment S1 may have a greater extension length than the fifth segment S5. For example, the second section S2 may be greater than the fourth section S4. For example, the angle a1 may be greater than the angle a2.

Hereinafter, with reference to FIGS. 14A to 14F, the change in angle between the first housing 310 and the second housing 320 based on the rotation of the hinge module 400 and the movement of the link structure 520 and the foot structure 510 will be described. The orientations of the X-axis, Y-axis, and Z-axis of FIGS. 14A to 14F are illustrated based on a partial enlarged view illustrating the foot structure 510.

In an embodiment, the angle between the first housing 310 and the second housing 320 may be changed between 0 degrees and about 180 degrees. For example, the open angle x may correspond to the rotation angle of the hinge module 400. Hereinafter, the angle between the first housing 310 and the second housing 320 is referred to as an "open angle x". In an embodiment, the foot structure 510 may be moved based on the unfolding and closing motion of the electronic device 300 or the rotation of the hinge module 400. For example, the foot structure 510 may be introduced into or withdrawn from the recess 380 (e.g., the recess 380 in FIG. 10) through the through hole 342 (e.g., the through hole 342 in FIG. 6). In an embodiment, the protrusion distance h of the foot structure 510 may be changed to correspond to the open angle x. For example, the protrusion distance h may refer to the distance that the foot structure 510 protrudes from the outer surface (the surface in the -Z direction) of the first rear surface cover 340 (e.g., the first rear surface cover 340 in FIG. 9).

According to an example, FIG. 14A may illustrates the electronic device 300 in the closed state when the open angle x is 0. FIG. 14B may illustrate the electronic device 300 in the intermediate state when the open angle x is a first predetermined angle x1. Referring to FIGS. 14A and 14B , according to an example, when the open angle x is 0 to the first predetermined angle x1, the second link member 522 may be positioned at the first section S1 of the guide slot 511a. For example, referring to FIG. 14A, when the open angle x is 0, the second link member 522 may be positioned adjacent to the first slot end 5111a of the guide slot 511a. For example, referring to FIG. 14B, when the open angle x is the first predetermined angle x1, the second link member 522 may be positioned adjacent to the opposite end of the first slot end 5111a of the first section S1. In an embodiment, when the open angle x is 0 to the first predetermined angle x1, the protrusion distance h may be 0. For example, the first predetermined angle x1 may be about 30 degrees.

As an example, FIGS. 14C and 14D may illustrate the electronic device 300 in an intermediate state or laptop mode. Referring to FIGS. 14C and 14D, according to an example, when the open angle x is between a second predetermined angle x2 and a third predetermined angle x3, the second link member 522 may be positioned in the third section S3 of the guide slot 511a. For example, referring to FIG. 14C, when the open angle x is the second predetermined angle x2, the second link member 522 may be positioned adjacent to one end of the third section S3 connected to the second section S2. For example, referring to FIG. 14D, when the open angle x is the third specified angle x3, the second link member 522 may be positioned adjacent to the other end of the third section S3 connected to the fourth section S4. According to an example, when the open angle x is changed from the second predetermined angle x2 to the third predetermined angle x3, the first pin member 441 may move in the +X direction. In an embodiment, when the open angle x is between the second predetermined angle x2 and the third predetermined angle x3, the protrusion distance h may be the first predetermined distance h1. For example, the first predetermined distance h1 may be about 1 mm. For example, the second predetermined angle x2 may be about 90 degrees. For example, the third predetermined angle x3 may be about 120 degrees.

According to an example, FIG. 14E may illustrate the electronic device 300 in the intermediate state when the open angle is a fourth predetermined angle x1. FIG. 14F may illustrates the electronic device 300 in the unfolded state when the open angle x is about 180 degrees. Referring to FIGS. 14E and 14F, according to an example, when the open angle x is between the fourth predetermined angle x4 and a fifth predetermined angle x5, the second link member 522 may be positioned in the fifth section S5 of the guide slot 511a. For example, referring to FIG. 14E, when the open angle x is the fourth predetermined angle x4, the second link member 522 may be positioned adjacent to one end of the fifth section S5 connected to the fourth section S4. For example, referring to FIG. 14F, when the open angle x is the fifth predetermined angle x5, the second link member 522 may be positioned adjacent to the second slot end 5112a. In an example, when the open angle x is changed from about the fourth predetermined angle to the fifth predetermined angle x3, the second link member 522 may move in the +X direction. In an embodiment, when the open angle x is between the fourth predetermined angle x4 and the fifth predetermined angle x5, the protrusion distance h may be 0. For example, the fourth predetermined angle x4 may be about 160 degrees. For example, the fifth predetermined angle x5 may be about 180 degrees.

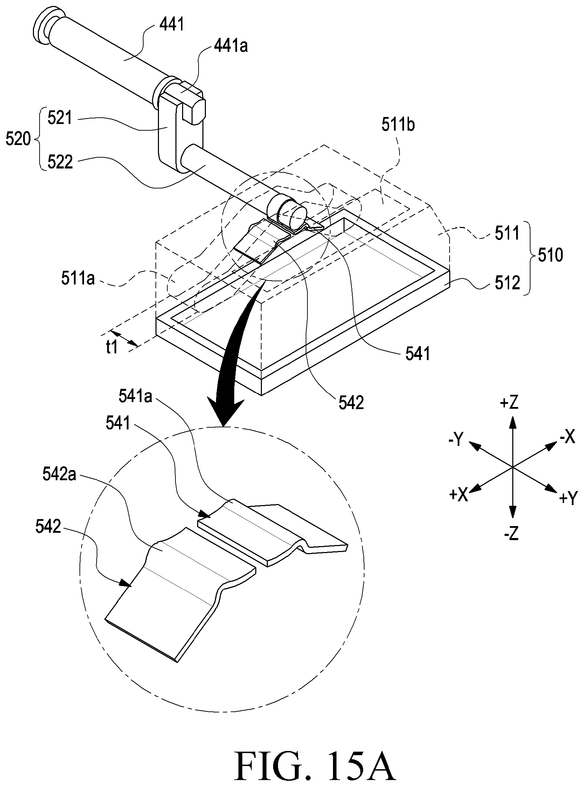

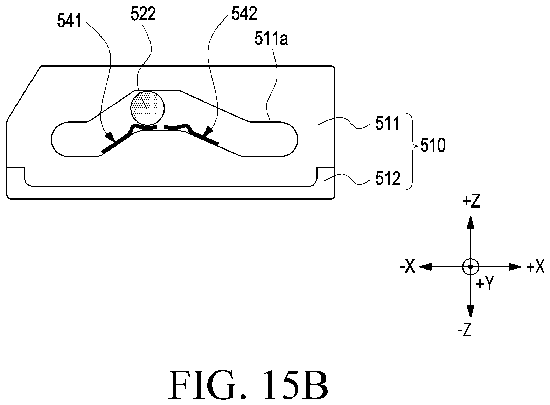

FIGS. 15A and 15B are views illustrating a foot structure and a plate member according to various embodiments of the disclosure.

The configurations of the foot structure 510 and the link structure 520 of FIGS. 15A and 15B may be entirely or partially equal to those of the foot structure 510 and the link structure 520 of FIGS. 13 and 14A to 14F.

Referring to FIGS. 15A and 15B, the guide slot 511a of the foot structure 510 (e.g., the guide slot 511a in FIGS. 13 and 14A to 14F.) may be formed on a side wall facing the link structure 520 of the first member 511 (e.g., the first member 511 in FIGS. 13 and 14A to 14F.). In an embodiment, the width t1 of the guide slot 511a may correspond to the thickness of the side wall of the first member 511.

In an embodiment, the foot structure 510 may include plate members 541 and 542 disposed in a portion of the guide slot 511a. In an embodiment, the plate members 541 and 542 may be disposed on a surface with which the second link member 522 of the guide slot 511a comes into contact. In an embodiment, the plate members 541 and 542 may prevent the second link member 522 from sliding on the contact surface of the guide slot 511a. In an embodiment, the friction coefficient of the plate members 541 and 542 may be higher than a friction coefficient of the first member 511. For example, the first plate member 541 may be disposed across a portion of the second section S2 to a portion of the third section S3 of the guide slot 511a. For example, the second plate member 542 may be disposed across a portion of the third section S3 to a portion of the fourth section S4 of the guide slot 511a. For example, the first plate member 541 and the second plate member 542 may be disposed not to overlap each other in the third section S3. For example, the end of the first plate member 541 positioned in the third section S3 and the end of the second plate member positioned in the third section S3 may be spaced apart from each other.

In an embodiment, the plate members 541 and 542 may include one or more uneven portions 541a and 542a, respectively. For example, the first plate member 541 may be bent such that a portion adjacent to the boundary between the second section S2 and the third section S3 forms a first uneven portion 541a. For example, the second plate member 542 may be bent such that a portion adjacent to the boundary between the third section S3 and the fourth section S4 forms a second uneven portion 542a. For example, the passage gap of the guide slot 511a through which the second link member 522 passes may be narrower in the portions where the uneven portions 541a and 542a are located than the height of the guide slot 511a (e.g., the height d1 of the guide slot 511a illustrated in FIG. 13). In an embodiment, when the second link member 522 passes over the uneven portions 541a and 542a based on the unfolding and folding of the electronic device 300 or the rotation of the hinge module 400, the uneven portions 541a and 542a may be pressed by the second link member 522. For example, the uneven portions 541a and 542a may be elastically deformed when pressed and may provide a resistance force and/or a clicking sensation to a user during the unfolding and folding operations of the electronic device 300. For example, the resistance force provided by the uneven portions 541a and 542a may reduce or prevent the unintentional accommodation of the foot structure 510 inside the electronic device 300 when an external force is applied. For example, the resistance force and/or the clicking sensation provided by the uneven portions 541a and 542a may allow the user to audibly and/or tactilely recognize the time point at which the second link member 522 enters the third section S3 and the foot structure 510 reaches its maximum protrusion (e.g., the state illustrated in FIG. 14C or 14D). For example, the resistance force and/or the clicking sensation may allow the user to audibly and/or tactilely recognize the time point at which the second link member 522 exits the third section S3 and the foot structure 510 is retracted into the interior of the electronic device 300 from its maximum protrusion (e.g., the state illustrated in FIG. 14C or 14D).

According to an embodiment disclosed herein, an electronic device (e.g., the electronic device 101 in FIG. 1, the electronic device 200 in FIGS. 2 to 4, and/or the electronic device 300 in FIG. 5, and FIGS. 14A to 14F) may include a first housing (e.g., the first housing 210 in FIGS. 2 to 4 and/or the first housing 310 in FIGS. 5, 8A, 8B, 9, 10, and 14A to 14F, and the first rear surface cover 240 in FIGS. 2 to 4 and/or the first rear surface cover 340 in FIGS. 8A, 8B, 9, and 14A to 14F), a second housing 320 (e.g., the second housing 220 in FIGS. 2 to 4 and/or the second housing 320 in FIGS. 5, 8A, 8B, 9, and 14A to 14F), a hinge module (e.g., the hinge module 164 in FIG. 4 and/or the hinge module 400 in FIGS. 5, 9, 11, and 12) disposed between the first housing 310 and the second housing 320 and rotatably connecting the second housing to the first housing, and a flexible display (e.g., the display 230 in FIGS. 2 to 4 and/or the display 330 in FIGS. 8A, 8B, and 9) disposed across one surface of the first housing, the hinge module, and one surface of the second housing. The electronic device may include a foot structure (e.g., the foot structure 510 in FIGS. 5 to 7, 8A, 8B, 9 to 13, 14A to 14F, 15A, and 15B) disposed adjacent to an outer surface of the first housing (e.g., the outer surface (the -Z direction surface) of the first rear surface cover 240 in FIGS. 2 to 4 and/or the first rear surface cover 340 in FIG. 9), and the foot structure may include a first member (e.g., the first member 511 in FIGS. 5 to 7, 8A, 8B, 9 to 13, 14A to 14F, 15A, and 15B) having a guide slot (e.g., the guide slot 511a in FIGS. 5 to 78A, 8B, 9 to 13, 14A to 14F, 15A, and 15B) formed therein. The electronic device may include a link structure (e.g., the link structure 520 in FIGS. 5 to 7, 8A, 8B, 10, 12, and 15A) including a first link member (e.g., the first link member 521 in 8A, 8B, 10, 12, and 15A) connected to the hinge module and/or a second link member (e.g., the second link member 522 in FIGS. 5 to 7, 8A, 8B, 10, 12, 14A to 14F, 15A, and 15B) connecting the first link member and the guide slot. The second link member may be movable along the guide slot in conjunction with rotation of at least one of the first housing or the second housing by the hinge module. The foot structure may be movable in a first direction (e.g., the direction indicated by arrow ② or the -Z direction in FIG. 6) toward an exterior of the first housing or in a second direction (e.g., the direction indicated by arrow ③ or the +Z direction in FIG. 6) opposite to the first direction in conjunction with movement of the second link member.

In an embodiment, the guide slot may include a first section (e.g., the first section S1 and the second section S2 in FIGS. 13 and 14A to 14F), a second section (e.g., the third section S3 in FIGS. 13 and 14A to 14F) having one end connected to the first section, and a third section (e.g., the fourth section S4 and the fifth section S5 in FIGS. 13 and 14A to 14F) connected to the other end of the second section. According to an embodiment, the first section may include a first diagonal area (e.g., the second section S2 in FIGS. 13 and 14A to 14F) extending away from the one end of the second section in a direction away from the display. According to an embodiment, the third section may include a second diagonal area (e.g., the fourth section S4 in FIGS. 13 and 14A to 14F) extending away from the other end of the second section in the direction away from the display.

In an embodiment, the foot structure may be configured to at least partially protrude from the outer surface of the first housing. According to an embodiment, the distance by which the foot structure protrudes from the outer surface of the first housing (e.g., the protrusion distance h in FIGS. 8B, 14C, and 14D) may be greater when the second link member is located in the second section than when the second link member is located in the first section or the third section.

In an embodiment, the first section may further include a first end (e.g., the first slot end 5111a in FIGS. 13 and 14A to 14F) and a first straight-line area (e.g., the first section S1 in FIGS. 13 and 14A to 14F) connecting the first end with the first diagonal area. According to an embodiment, the third section may further include a second end (e.g., the second slot end 5112a in FIGS. 13 and 14A to 14F) and a second straight-line area (e.g., the fifth section S5 in FIGS. 13 and 14A to 14F) connecting the second end with the second diagonal area.

In an embodiment, the first section and the third section may extend away from each other from the one end and the other end of the second section, respectively.

In an embodiment, when the second link member is located in the second section, the angle formed by the first housing and the second housing (e.g., the hinge angle x in FIGS. 14A to 14F) may be equal to or greater than a first predetermined angle, which is not zero, and equal to or smaller than a second predetermined angle, and the foot structure may protrude from the outer surface of the first housing by a predetermined distance.

In an embodiment, when the second link member is located in the first section or the third section, the angle formed by the first housing and the second housing may be smaller than the first predetermined angle or greater than the second predetermined angle, and the distance by which the foot structure protrudes from the outer surface of the first housing may be smaller than the predetermined distance.

In an embodiment, when the second link member is located in the first straight-line area or the second straight-line area, the foot structure may not protrude from the outer surface of the first housing.

In an embodiment, at least a portion of the second link member is accommodated in the guide slot, and the foot structure may include at least one plate member (e.g., the first plate member 541 and the second plate member 542 in FIGS. 15A and 15B) disposed between the guide slot and the second link member. According to an embodiment, the at least one plate member may be disposed over at least a portion of the second section and at least a portion of at least one of the first diagonal area or the second diagonal area.

In an embodiment, the first housing may include an inner space (e.g., the recess 380 in FIG. 10 and/or FIGS. 14A to 14F) defined between the one surface and an outer surface opposite to the one surface, and a through hole (e.g., the through hole 342 in FIG. 6 and FIGS. 14A to 14F) formed in a portion of the outer surface to be connected to the inner space. According to an embodiment, the foot structure may be at least partially accommodated in the inner space and may be disposed to movable in the first direction or the second direction through the through hole.

In an embodiment, the electronic device may further include a foot structure holder (e.g., the foot structure holder in FIGS. 5, 8A, 8B, 10, and 11) including a guide hole (e.g., the holder portion 531 in FIG. 10) connected to the first housing and configured to accommodate the foot structure. According to an embodiment, the guide hole may penetrate in the first direction, and the foot structure may be configured to move in the first direction or the second direction through the guide hole.

In an embodiment, the hinge module may include a rotation member (e.g., the first rotation member 411 in FIGS. 5 to 7, 8A, and 12) connected to the first housing and including a pin slot (e.g., the first pin slot 411a in FIGS. 6, 7, and 12), and a pin member (e.g., the first pin member 441 in FIGS. 5 to 7, 8A, 8B, 11, and 12) configured to slide within the pin slot in conjunction with movement of the second housing. According to an embodiment, the first member may be connected to the pin member and may move with the pin member.

In an embodiment, a direction (e.g., the direction indicated by arrow ① or the X-axis direction in FIG. 6) of slide movement of the pin member may be perpendicular to the first direction or the second direction.

In an embodiment, based on the first direction, the foot structure may at least partially overlap with the rotation member.

In an embodiment, the foot structure may further include a second member that extends from the first member and is configured to protrude from the outer surface of the first housing. According to an embodiment, the second portion of the foot structure may have a friction coefficient greater than a friction coefficient of at least one of the first housing or the first portion.

According to an embodiment disclosed herein, An electronic device (e.g., the electronic device 101 in FIG. 1, the electronic device 200 in FIGS. 2 to 4, and/or the electronic device 300 in FIGS. 5 and 14A to 14F) may include a first housing (e.g., the first housing 210 in FIGS. 2 to 4 and/or the first housing 310 in FIGS. 5, 8A, 8B, 9, 10, and 14A to 14F, the first rear surface cover 240 in FIGS. 2 to 4, and/or the first rear surface cover 340 in FIGS. 8A, 8B, 9, and 14A to 14F), a second housing 320 (e.g., the second housing 220 in FIGS. 2 to 4 and/or the second housing 320 in FIGS. 5, 8A, 8B, 9, and 14A to 14F), a hinge module (e.g., the hinge module 164 in FIG. 4 and/or the hinge module 400 in FIGS. 5, 9, 11, and 12) disposed between the first housing 310 and the second housing 320 and rotatably connecting the second housing to the first housing, and/or a display (e.g., the display 230 in FIGS. 2 to 4 and/or the display 330 in FIGS. 8A, 8B, and 9) disposed across one surface of the first housing, the hinge module, and one surface of the second housing. According to an embodiment, the hinge module may include a pin member (e.g., the first rotation member 411 in FIGS. 5 to 7, 8A, 8B, and 12) disposed within the first housing and slidably moving in conjunction with the rotation of at least one of the first housing or the second housing. According to an embodiment, the electronic device may include a foot structure disposed adjacent to the outer surface of the first housing (e.g., the outer surface (the -Z direction surface) of the first rear surface cover 240 in FIGS. 2 to 4 and/or the first rear surface cover 340 in FIG. 9), and the foot structure may include a guide slot (e.g., the guide slot 511a in FIGS. 5 to 7, 8A, 8B, 9 to 13, 14A to 14F, 15A, and 15B) and configured such that at least a portion thereof (e.g., the second member 512 of FIGS. 5 to 7, 8A, 8B, 9 to 13, 14A to 14F, 15A, and 15B) can protrude from the outer surface of the first housing. According to an embodiment, the electronic device may include a link member (e.g., the link structure 520 in FIGS. 5 to 7, 8A, 8B, 10, 12, and 15A) connected to the pin member and the guide slot and moving along the guide slot in conjunction with the sliding of the pin member. According to an embodiment, the foot structure may be movable in a first direction (e.g., the direction indicated by arrow ② or the -Z direction in FIG. 6) toward the exterior of the first housing or in a second direction (e.g., the direction indicated by arrow ③ or the +Z direction in FIG. 6) opposite to the first direction in conjunction with movement of the link member.

In an embodiment, the guide slot may include a first section (e.g., the first section S1 and the second section S2 in FIGS. 13, 14A to 14F), a second section (e.g., the third section S3 in FIGS. 13, 14A to 14F) having one end connected to the first section, and a third section (e.g., the fourth section S4 and the fifth section S5 in FIGS. 13, 14A to 14F) connected to the other end of the second section. According to an embodiment, the first section may include a first diagonal area (e.g., the second section S2 in FIGS. 13, 14A to 14F) extending away from the one end of the second section in a direction away from the display. According to an embodiment, the third section may include a second diagonal area (e.g., the fourth section S4 in FIGS. 13, 14A to 14F) extending away from the other end of the second section in the direction away from the display.

In an embodiment, the distance by which the foot structure protrudes from the outer surface of the first housing (e.g., the protrusion distance h in FIGS. 8B, 14C, and 14D) may be greater when the second link member is located in the second section than when the second link member is located in the first section or the third section.

In an embodiment, the first section may further include a first end (e.g., the first slot end 5111a in FIGS. 13, 14A to 14F) and a first straight-line area (e.g., the first section S1 in FIGS. 13, 14A to 14F) connecting the first end with the first diagonal area. According to an embodiment, the third section may further include a second end (e.g., the second slot end 5112a in FIGS. 13, 14A to 14F) and a second straight-line area (e.g., the fifth section S5 in FIGS. 13, 14A to 14F) connecting the second end with the second diagonal area.

The electronic device including the hinge module, link structure, and foot structure according to the embodiments disclosed herein are not limited to the aforementioned embodiments and drawings, and it will be apparent to those ordinarily skilled in the art that various substitutions.

The electronic device according to an embodiment may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that an embodiment of the disclosure and the terms used therein are not intended to limit the technological features set forth herein to particular embodiments and include various changes, equivalents, or replacements for a corresponding embodiment. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with an embodiment of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to an embodiment, each component (e.g., a module or a program) of the above-described components may include a single entity or multiple entities, and some of the multiple entities may be separately disposed in different components. According to an embodiment, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to an embodiment, operations performed by the module, the program, or another component may be carried out sequentially, in parallel, repeatedly, or heuristically, or one or more of the operations may be executed in a different order or omitted, or one or more other operations may be added.

## Claims

1. An electronic device (101; 200; 300) comprising:
a first housing (210; 310);
a second housing (220; 320);
a hinge module (164; 400) disposed between the first housing (210; 310) and the second housing (220; 320) and rotatably connecting the second housing (220; 320) to the first housing (210; 310); and
a flexible display (230; 330) disposed across one surface of the first housing (210; 310), the hinge module (164; 400), and one surface of the second housing (220; 320), the electronic device **characterised by** further comprising:
a foot structure (510) disposed adjacent to an outer surface of the first housing (210; 310) and comprising a first member (511) on which a guide slot (511a) is formed; and
a link structure (520) comprising a first link member (521) connected to the hinge module (164; 400) and a second link member (522) connecting the first link member (521) and the guide slot (511a),
wherein the second link member (522) is configured to move along the guide slot (511a) in conjunction with rotation of at least one of the first housing (210; 310) or the second housing (220; 320) by the hinge module (164; 400), and
wherein the foot structure (510) is configured to move in a first direction toward an exterior of the first housing (210; 310) or in a second direction opposite to the first direction in conjunction with movement of the second link member (522).

2. The electronic device (101; 200; 300) of claim 1,
wherein the guide slot (511a) comprises a first section (S1, S2), a second section (S3) having one end connected to the first section (S1, S2), and a third section (S4, S5) connected to the other end of the second section (S3),
wherein the first section (S1, S2) comprises a first diagonal area (S2) extending away from the one end of the second section (S3) in a direction away from the display, and
wherein the third section (S4, S5) comprises a second diagonal area (S4) extending away from the other end of the second section (S3) in a direction away from the display.

3. The electronic device (101; 200; 300) of claim 2,
wherein the foot structure (510) is configured to at least partially protrude from the outer surface of the first housing (210; 310), and
wherein a distance by which the foot structure (510) protrudes from an outer surface of the first housing (210; 310) is greater when the second link member (522) is located in the second section (S3) than when the second link member (522) is located in the first section (S1, S2) or the third section (S4, S5).

4. The electronic device (101; 200; 300) of claim 2,
wherein the first section (S1, S2) further comprises a first end (5111a) and a first straight-line area (S1) connecting the first end with the first diagonal area, and
wherein the third section (S4, S5) further comprises a second end (5112a) and a second straight-line area (S5) connecting the second end with the second diagonal area.

5. The electronic device (101; 200; 300) of claim 2, wherein the first section (S1, S2) and the third section (S4, S5) extend away from each other from the one end and the other end of the second section (S3), respectively.

6. The electronic device (101; 200; 300) of claim 2, wherein, when the second link member (522) is located in the second section (S3), an angle formed by the first housing (210; 310) and the second housing (220; 320) is equal to or greater than a first predetermined angle, which is not zero, and equal to or smaller than a second predetermined angle, and the foot structure (510) protrudes from the outer surface of the first housing (210; 310) by a predetermined distance.

7. The electronic device (101; 200; 300) of claim 6, wherein, when the second link member (522) is located in the first section (S1, S2) or the third section (S4, S5), the angle formed by the first housing (210; 310) and the second housing (220; 320) is smaller than the first predetermined angle or greater than the second predetermined angle, and the distance by which the foot structure (510) protrudes from the outer surface of the first housing (210; 310) is smaller than the predetermined distance.

8. The electronic device (101; 200; 300) of claim 4, wherein, when the second link member (522) is located in the first straight-line area or the second straight-line area, the foot structure (510) does not protrude from the outer surface of the first housing (210; 310).

9. The electronic device (101; 200; 300) of claim 2,
wherein at least a portion of the second link member (522) is accommodated in the guide slot (511a), and
wherein the foot structure (510) comprises at least one plate member (541, 542) disposed between the guide slot (511a) and the second link member (522), the plate member (541, 542) being disposed over at least a portion of the second section (S3) and at least a portion of at least one of the first diagonal area or the second diagonal area.

10. The electronic device (101; 200; 300) of claim 1,
wherein the first housing (210; 310) comprises:
an inner space (380) defined between the one surface and an outer surface opposite to the one surface, and
a through hole (342) formed in a portion of the outer surface to be connected to the inner space, and
wherein the foot structure (510) is at least partially accommodated in the inner space and is disposed to be movable in the first direction or the second direction through the through hole.

11. The electronic device (101; 200; 300) of claim 1, further comprising:
a foot structure holder (530) comprising a guide hole connected to the first housing (210; 310) and configured to accommodate the foot structure (510),
wherein the guide hole penetrates in the first direction, and
wherein the foot structure (510) is configured to move in the first direction or the second direction through the guide hole.

12. The electronic device (101; 200; 300) of claim 1,
wherein the hinge module (164; 400) comprises:
a rotation member (411) connected to the first housing (210; 310) and comprising a pin slot (411a), and
a pin member (441) configured to slide within the pin slot (411a) in conjunction with movement of the second housing (220; 320), and
wherein the first member (511) is connected to the pin member (441) and moves with the pin member (441).

13. The electronic device (101; 200; 300) of claim 12, wherein a direction of slide movement of the pin member (441) is perpendicular to the first direction or the second direction.

14. The electronic device (101; 200; 300) of claim 12, wherein, based on the first direction, the foot structure (510) at least partially overlaps with the rotation member (411).

15. The electronic device (101; 200; 300) of claim 1,
wherein the foot structure (510) further comprises a second member that extends from the first member (511) and is configured to protrude from the outer surface of the first housing (210; 310), and
wherein the second member has a friction coefficient greater than a friction coefficient of at least one of the first housing (210; 310) or the first member (511).

## Patentansprüche

1. Elektronische Vorrichtung (101; 200; 300), umfassend:
ein erstes Gehäuse (210; 310);
ein zweites Gehäuse (220; 320);
ein Gelenkmodul (164; 400), das zwischen dem ersten Gehäuse (210; 310) und dem zweiten Gehäuse (220; 320) angeordnet ist und das zweite Gehäuse (220; 320) drehbar mit dem ersten Gehäuse (210; 310) verbindet; und
eine flexible Anzeige (230; 330), die über einer Fläche des ersten Gehäuses (210; 310), dem Gelenkmodul (164; 400) und einer Fläche des zweiten Gehäuses (220; 320) angeordnet ist;
wobei die elektronische Vorrichtung **dadurch gekennzeichnet** ist, das sie ferner Folgendes umfasst:
eine Fußstruktur (510), die benachbart zu einer Außenfläche des ersten Gehäuses (210; 310) angeordnet ist und ein erstes Element (511) umfasst, auf dem ein Führungsschlitz (511a) ausgebildet ist; und
eine Verbindungsstruktur (520), die ein erstes Verbindungselement (521), das mit dem Gelenkmodul (164; 400) verbunden ist, und ein zweites Verbindungselement (522), welches das erste Verbindungselement (521) und den Führungsschlitz (511a) verbindet, umfasst,
wobei das zweite Verbindungselement (522) dazu ausgelegt ist, sich entlang des Führungsschlitzes (511a) in Verbindung mit einer Drehung von mindestens einem von dem ersten Gehäuse (210; 310) oder dem zweiten Gehäuse (220; 320) durch das Gelenkmodul (164; 400) zu bewegen, und
wobei die Fußstruktur (510) dazu ausgelegt ist, sich in einer ersten Richtung zu einem Äußeren des ersten Gehäuses (210; 310) hin oder in einer zweiten Richtung entgegengesetzt zu der ersten Richtung in Verbindung mit einer Bewegung des zweiten Verbindungselements (522) zu bewegen.

2. Elektronische Vorrichtung (101; 200; 300) nach Anspruch 1,
wobei der Führungsschlitz (511a) einen ersten Abschnitt (S1, S2), einen zweiten Abschnitt (S3), der ein Ende aufweist, das mit dem ersten Abschnitt (S1, S2) verbunden ist, und einen dritten Abschnitt (S4, S5), der mit dem anderen Ende des zweiten Abschnitts (S3) verbunden ist, umfasst,
wobei der erste Abschnitt (S1, S2) einen ersten diagonalen Bereich (S2) umfasst, der sich weg von dem einen Ende des zweiten Abschnitts (S3) in einer Richtung weg von der Anzeige erstreckt, und
wobei der dritte Abschnitt (S4, S5) einen zweiten diagonalen Bereich (S4) umfasst, der sich weg von dem anderen Ende des zweiten Abschnitts (S3) in einer Richtung weg von der Anzeige erstreckt.

3. Elektronische Vorrichtung (101; 200; 300) nach Anspruch 2,
wobei die Fußstruktur (510) so ausgelegt ist, dass sie zumindest teilweise von der Außenfläche des ersten Gehäuses (210; 310) vorsteht, und
wobei ein Abstand, um den die Fußstruktur (510) von einer Außenfläche des ersten Gehäuses (210; 310) vorsteht, größer ist, wenn sich das zweite Verbindungselement (522) in dem zweiten Abschnitt (S3) befindet, als wenn sich das zweite Verbindungselement (522) in dem ersten Abschnitt (S1, S2) oder dem dritten Abschnitt (S4, S5) befindet.

4. Elektronische Vorrichtung (101; 200; 300) nach Anspruch 2,
wobei der erste Abschnitt (S1, S2) ferner ein erstes Ende (5111a) und einen ersten geraden Bereich (S1), der das erste Ende mit dem ersten diagonalen Bereich verbindet, umfasst und
wobei der dritte Abschnitt (S4, S5) ferner ein zweites Ende (5112a) und einen zweiten geraden Bereich (S5), der das zweite Ende mit dem zweiten diagonalen Bereich verbindet, umfasst.

5. Elektronische Vorrichtung (101; 200; 300) nach Anspruch 2, wobei sich der erste Abschnitt (S1, S2) und der dritte Abschnitt (S4, S5) von dem einen Ende bzw. dem anderen Ende des zweiten Abschnitts (S3) voneinander weg erstrecken.

6. Elektronische Vorrichtung (101; 200; 300) nach Anspruch 2, wobei, wenn sich das zweite Verbindungselement (522) in dem zweiten Abschnitt (S3) befindet, ein von dem ersten Gehäuse (210; 310) und dem zweiten Gehäuse (220; 320) gebildeter Winkel gleich oder größer als ein erster vorbestimmter Winkel, der ungleich null ist, und gleich oder kleiner als ein zweiter vorbestimmter Winkel ist und die Fußstruktur (510) von der Außenfläche des ersten Gehäuses (210; 310) um einen vorbestimmten Abstand vorsteht.

7. Elektronische Vorrichtung (101; 200; 300) nach Anspruch 6, wobei, wenn sich das zweite Verbindungselement (522) in dem ersten Abschnitt (S1, S2) oder dem dritten Abschnitt (S4, S5) befindet, der von dem ersten Gehäuse (210; 310) und dem zweiten Gehäuse (220; 320) gebildete Winkel kleiner als der erste vorbestimmte Winkel oder größer als der zweite vorbestimmte Winkel ist und der Abstand, um den die Fußstruktur (510) von der Außenfläche des ersten Gehäuses (210; 310) vorsteht, kleiner als der vorbestimmte Abstand ist.

8. Elektronische Vorrichtung (101; 200; 300) nach Anspruch 4, wobei, wenn sich das zweite Verbindungselement (522) in dem ersten geraden Bereich oder dem zweiten geraden Bereich befindet, die Fußstruktur (510) nicht von der Außenfläche des ersten Gehäuses (210; 310) vorsteht.

9. Elektronische Vorrichtung (101; 200; 300) nach Anspruch 2,
wobei mindestens ein Teil des zweiten Verbindungselements (522) in dem Führungsschlitz (511a) aufgenommen ist und
wobei die Fußstruktur (510) mindestens ein Plattenelement (541, 542) umfasst, das zwischen dem Führungsschlitz (511a) und dem zweiten Verbindungselement (522) angeordnet ist, wobei das Plattenelement (541, 542) über mindestens einem Teil des zweiten Abschnitts (S3) und mindestens einem Teil von mindestens einem von dem ersten diagonalen Bereich oder dem zweiten diagonalen Bereich angeordnet ist.

10. Elektronische Vorrichtung (101; 200; 300) nach Anspruch 1,
wobei das erste Gehäuse (210; 310) Folgendes umfasst:
einen Innenraum (380), der zwischen der einen Fläche und einer Außenfläche gegenüber der einen Fläche definiert ist, und
ein Durchgangsloch (342), das in einem Teil der Außenfläche ausgebildet ist, sodass es mit dem Innenraum verbunden ist, und
wobei die Fußstruktur (510) zumindest teilweise in dem Innenraum aufgenommen und so angeordnet ist, dass sie in der ersten Richtung oder der zweiten Richtung durch das Durchgangsloch beweglich ist.

11. Elektronische Vorrichtung (101; 200; 300) nach Anspruch 1, ferner umfassend:
einen Fußstrukturhalter (530), der ein Führungsloch umfasst, das mit dem ersten Gehäuse (210; 310) verbunden und dazu ausgelegt ist, die Fußstruktur (510) aufzunehmen,
wobei das Führungsloch in der ersten Richtung hindurchdringt und
wobei die Fußstruktur (510) dazu ausgelegt ist, sich in der ersten Richtung oder der zweiten Richtung durch das Führungsloch zu bewegen.

12. Elektronische Vorrichtung (101; 200; 300) nach Anspruch 1,
wobei das Gelenkmodul (164; 400) Folgendes umfasst:
ein Drehelement (411), das mit dem ersten Gehäuse (210; 310) verbunden ist und einen Stiftschlitz (411a) umfasst, und
ein Stiftelement (441), das dazu ausgelegt ist, sich innerhalb des Stiftschlitzes (411a) in Verbindung mit einer Bewegung des zweiten Gehäuses (220; 320) zu verschieben, und
wobei das erste Element (511) mit dem Stiftelement (441) verbunden ist und sich mit dem Stiftelement (441) bewegt.

13. Elektronische Vorrichtung (101; 200; 300) nach Anspruch 12, wobei eine Richtung einer Verschiebungsbewegung des Stiftelements (441) senkrecht zu der ersten Richtung oder der zweiten Richtung verläuft.

14. Elektronische Vorrichtung (101; 200; 300) nach Anspruch 12, wobei die Fußstruktur (510) auf Grundlage der ersten Richtung das Drehelement (411) zumindest teilweise überlappt.

15. Elektronische Vorrichtung (101; 200; 300) nach Anspruch 1,
wobei die Fußstruktur (510) ferner ein zweites Element umfasst, das sich von dem ersten Element (511) erstreckt und so ausgelegt ist, dass es von der Außenfläche des ersten Gehäuses (210; 310) vorsteht, und
wobei das zweite Element einen Reibungskoeffizienten aufweist, der größer als ein Reibungskoeffizient von mindestens einem von dem ersten Gehäuse (210; 310) oder dem ersten Element (511) ist.

## Revendications

1. Dispositif électronique (101 ; 200 ; 300) comprenant :
un premier boîtier (210 ; 310) ;
un deuxième boîtier (220 ; 320) ;
un module de charnière (164 ; 400) disposé entre le premier boîtier (210 ; 310) et le deuxième boîtier (220 ; 320) et reliant en rotation le deuxième boîtier (220 ; 320) au premier boîtier (210 ; 310) ; et
un affichage flexible (230 ; 330) disposé sur une surface du premier boîtier (210 ; 310), le module de charnière (164 ; 400) et une surface du deuxième boîtier (220 ; 320) ;
dans lequel le dispositif électronique est **caractérisé en ce qu'**il comprend en outre :
une structure de pied (510) disposée de manière adjacente à une surface extérieure du premier boîtier (210 ; 310) et comprenant un premier élément (511) sur lequel est formée une fente de guidage (511a) ; et
une structure de liaison (520) comprenant un premier élément de liaison (521) relié au module de charnière (164 ; 400) et un deuxième élément de liaison (522) reliant le premier élément de liaison (521) et la fente de guidage (511a),
dans lequel le deuxième élément de liaison (522) est configuré pour se déplacer le long de la fente de guidage (511a) conjointement avec la rotation d'au moins l'un parmi le premier boîtier (210 ; 310) ou le deuxième boîtier (220 ; 320) par le module de charnière (164 ; 400), et
dans lequel la structure de pied (510) est configurée pour se déplacer dans une première direction vers l'extérieur du premier boîtier (210 ; 310) ou dans une deuxième direction opposée à la première direction conjointement avec le déplacement du deuxième élément de liaison (522).

2. Dispositif électronique (101 ; 200 ; 300) selon la revendication 1,
dans lequel la fente de guidage (511a) comprend une première section (S1, S2), une deuxième section (S3) dont une extrémité est reliée à la première section (S1, S2) et une troisième section (S4, S5) reliée à l'autre extrémité de la deuxième section (S3),
dans lequel la première section (S1, S2) comprend une première zone diagonale (S2) s'étendant à l'opposé de l'une extrémité de la deuxième section (S3) dans une direction opposée à l'affichage, et
dans lequel la troisième section (S4, S5) comprend une deuxième zone diagonale (S4) s'étendant à l'opposé de l'autre extrémité de la deuxième section (S3) dans une direction opposée à l'affichage.

3. Dispositif électronique (101 ; 200 ; 300) selon la revendication 2,
dans lequel la structure de pied (510) est configurée pour faire saillie au moins partiellement par rapport à la surface extérieure du premier boîtier (210 ; 310), et
dans lequel une distance de saillie de la structure de pied (510) par rapport à une surface extérieure du premier boîtier (210 ; 310) est plus grande lorsque le deuxième élément de liaison (522) est situé dans la deuxième section (S3) que lorsque le deuxième élément de liaison (522) est situé dans la première section (S1, S2) ou la troisième section (S4, S5).

4. Dispositif électronique (101 ; 200 ; 300) selon la revendication 2,
dans lequel la première section (S1, S2) comprend en outre une première extrémité (5111a) et une première zone rectiligne (S1) reliant la première extrémité à la première zone diagonale, et
dans lequel la troisième section (S4, S5) comprend en outre une deuxième extrémité (5112a) et une deuxième zone rectiligne (S5) reliant la deuxième extrémité à la deuxième zone diagonale.

5. Dispositif électronique (101 ; 200 ; 300) selon la revendication 2, dans lequel la première section (S1, S2) et la troisième section (S4, S5) s'étendent à l'opposé l'une de l'autre à partir de l'une extrémité et l'autre extrémité de la deuxième section (S3), respectivement.

6. Dispositif électronique (101 ; 200 ; 300) selon la revendication 2, dans lequel, lorsque le deuxième élément de liaison (522) est situé dans la deuxième section (S3), un angle formé par le premier boîtier (210 ; 310) et le deuxième boîtier (220 ; 320) est égal ou supérieur à un premier angle prédéterminé, qui n'est pas nul, et égal ou inférieur à un deuxième angle prédéterminé, et la structure de pied (510) fait saillie par rapport à la surface extérieure du premier boîtier (210 ; 310) d'une distance prédéterminée.

7. Dispositif électronique (101 ; 200 ; 300) selon la revendication 6, dans lequel, lorsque le deuxième élément de liaison (522) est situé dans la première section (S1, S2) ou la troisième section (S4, S5), l'angle formé par le premier boîtier (210 ; 310) et le deuxième boîtier (220 ; 320) est inférieur au premier angle prédéterminé ou supérieur au deuxième angle prédéterminé, et la distance de saillie de la structure de pied (510) par rapport à la surface extérieure du premier boîtier (210 ; 310) est inférieure à la distance prédéterminée.

8. Dispositif électronique (101 ; 200 ; 300) selon la revendication 4, dans lequel, lorsque le deuxième élément de liaison (522) est situé dans la première zone rectiligne ou la deuxième zone rectiligne, la structure de pied (510) ne fait pas saillie par rapport à la surface extérieure du premier boîtier (210 ; 310).

9. Dispositif électronique (101 ; 200 ; 300) selon la revendication 2,
dans lequel au moins une partie du deuxième élément de liaison (522) est logée dans la fente de guidage (511a), et
dans lequel la structure de pied (510) comprend au moins un élément de plaque (541, 542) disposé entre la fente de guidage (511a) et le deuxième élément de liaison (522), l'élément de plaque (541, 542) étant disposé sur au moins une partie de la deuxième section (S3) et au moins une partie d'au moins une parmi la première zone diagonale ou la deuxième zone diagonale.

10. Dispositif électronique (101 ; 200 ; 300) selon la revendication 1,
dans lequel le premier boîtier (210 ; 310) comprend :
un espace intérieur (380) défini entre ladite surface et une surface extérieure opposée à ladite surface, et
un trou traversant (342) formé dans une partie de la surface extérieure à relier à l'espace intérieur, et
dans lequel la structure de pied (510) est au moins partiellement logée dans l'espace intérieur et est disposée de façon à être mobile dans la première direction ou la deuxième direction à travers le trou traversant.

11. Dispositif électronique (101 ; 200 ; 300) selon la revendication 1, comprenant en outre :
un support de structure de pied (530) comprenant un trou de guidage relié au premier boîtier (210 ; 310) et configuré pour recevoir la structure de pied (510),
dans lequel le trou de guidage pénètre dans la première direction, et
dans lequel la structure de pied (510) est configurée pour se déplacer dans la première direction ou la deuxième direction à travers le trou de guidage.

12. Dispositif électronique (101 ; 200 ; 300) selon la revendication 1,
dans lequel le module de charnière (164 ; 400) comprend :
un élément de rotation (411) relié au premier boîtier (210 ; 310) et comprenant une fente pour broche (411a), et
un élément de broche (441) configuré pour coulisser dans la fente pour broche (411a) conjointement avec le déplacement du deuxième boîtier (220 ; 320), et
dans lequel le premier élément (511) est relié à l'élément de broche (441) et se déplace avec l'élément de broche (441).

13. Dispositif électronique (101 ; 200 ; 300) selon la revendication 12, dans lequel une direction de coulissement de l'élément de broche (441) est perpendiculaire à la première direction ou à la deuxième direction.

14. Dispositif électronique (101 ; 200 ; 300) selon la revendication 12, dans lequel, à partir de la première direction, la structure de pied (510) chevauche au moins partiellement l'élément de rotation (411).

15. Dispositif électronique (101 ; 200 ; 300) selon la revendication 1,
dans lequel la structure de pied (510) comprend en outre un deuxième élément qui s'étend à partir du premier élément (511) et est configuré pour faire saillie par rapport à la surface extérieure du premier boîtier (210 ; 310), et
dans lequel le deuxième élément présente un coefficient de frottement supérieur à un coefficient de frottement d'au moins un parmi le premier boîtier (210 ; 310) ou le premier élément (511).
